# EUROPEAN PATENT APPLICATION

(11) **EP 3 678 173 A1**
(43) Date of publication of application: **08.07.2020**
(21) Application number: 18850023.5
(22) Date of filing: 03.09.2018
(51) Int. Cl.: H01L 23/367, H01L 23/473, H01L 23/48, H01L 25/16, H01L 25/07

(54) **ELECTRICAL DEVICE AND ELECTRICAL APPARATUS**

(30) Priority: 01.09.2017 CN 201710776469; 25.07.2018 CN 201810827090; 25.07.2018 CN 201810829497; 25.07.2018 CN 201810829499
(71) Applicant: Tsinghua University, Beijing 100084 (CN); Sichuan Energy Internet Research Institute Tsinghhua University, Sichuan 610213 (CN)
(72) Inventor: ZENG, Rong, Beijing 100084 (CN); CHEN, Zhengyu, Beijing 100084 (CN); LIU, Jiapeng, Beijing 100084 (CN); ZHOU, Wenpeng, Beijing 100084 (CN); ZHAO, Biao, Beijing 100084 (CN); YU, Zhanqing, Beijing 100084 (CN)
(74) Representative: Sadler, Peter Frederick
(86) International application number: PCT/CN2018/103750
(87) International publication number: WO 2019/042446

(57) **Abstract**

The present disclosure relates to an electrical device and an electrical apparatus. An electrical device is provided which comprises: a semiconductor substrate having a power semiconductor device thereon, wherein a control electrode and a first current electrode of the power semiconductor device are arranged on a surface of the semiconductor substrate; a printed circuit board on which a driving module for driving the power semiconductor device is arranged, the driving module comprising at least one first switching element, and each of the first switching elements comprising a control terminal and current terminals; a first conductive piece disposed between the semiconductor substrate and the printed circuit board and used to provide an electrical connection to the first current electrode; one or more connecting members each of which passes through, and is electrically isolated from, the first conductive piece, and is connected to a part of the control electrode, and each being associated with a corresponding first switch element; and one or more first spring members, each of which is interposed between a corresponding connecting member and a first switching element associated with the corresponding connecting member, so that a first current terminal of the current terminals of each first switching element is electrically connected to a part of the control electrode through the connecting member.

## Description

### CROSS-REFERENCE TO RELATED APPLICATIONS

The present application claims priority to Chinese application No. 201710776469.8 filed on September 1, 2017, Chinese application No. 201810829499.5 filed on July 25, 2018, Chinese application No. 201810827090.X filed on July 25, 2018, and Chinese Application No. 201810829497.6, filed on July 25, 2018, which are hereby incorporated by reference in their entireties.

### TECHNICAL FIELD

The present disclosure relates to electric devices comprising a power component and electric apparatuses comprising the electric devices.

### BACKGROUND

As power electronics technology develops rapidly, requirements for power semiconductor devices (herein referred to as semiconductor devices or power devices for short), such as fast commutation speed when turning off, high turn-off reliability, and good heat dissipation performance, are set forth by the users. The package structure for the power semiconductor device is particularly critical for good electrical connection between the semiconductor device and an external circuit, especially for a power semiconductor device suitable for use in a high voltage and high current application.

With the continuous development of semiconductor technology, higher requirements have been put forward to the key indicators for measuring the performances of power semiconductor components, such as capability to turn off current or the commutation speed. The capability to turn-off current or commutation speed is largely affected by the stray inductance yield by the commutation loop inside the semiconductor device. If the stray inductance is too large, some cells in the semiconductor device may not be completely commutated during the turn-off process, which may cause the turn-off process to fail. In general, power semiconductor components often cooperate with a turn-on module and/or a turn-off module. The turn-on module and/or the turn-off module may be used or assist to turn on and/or turn off the power semiconductor device. Conventionally, in a power semiconductor device, a power semiconductor component (sometimes also referred to as a device wafer, a device chip, or a device die) is usually placed in a separate package (also referred to as a case), and a drive module (such as, turn-on module and/or turn-off module) is placed outside the package. This arrangement will cause the area of the commutation loop to be larger, which in turn will result in a larger stray inductance in the commutation loop. In addition, during or after packaging, the mechanical pressure on the elements of the semiconductor device may be much greater than the pressure that the circuit elements in the drive module can withstand, which may possibly cause damage to the circuit elements.

Therefore, there is a need in the related art for improved electrical devices and power devices including power components.

### SUMMARY

In order to alleviate or overcome some or all of the above problems and other problems, the inventors of the present application propose electrical devices and electrical apparatuses as disclosed in this application after having been intensively studied the package structure for semiconductor devices.

The electrical devices according to the present disclosure have compact structures, and the size of the commutation loop and the stray inductance of the commutation loop can be effectively reduced. According to the electric devices and the electric apparatuses of the present disclosure, commutation speed can be increased, the capability to turn off current can be increased, and the turn-off reliability can be improved. The electrical devices according to the present disclosure can be prepared or assembled by press-bonding or pressure fitting, ensuring reliable contact between the components thereof by pressure, reducing contact resistance, and thereby improving coupling between the components. According to the electrical devices of the present disclosure, the reliability and redundancy of the connections can be improved, and the probability of failure can be reduced. In addition, according to the electrical devices and the electrical devices of the present disclosure, a relatively large pressure can be employed, without causing damage to the circuit elements in the turn-on module and/or turn-off module. The electric devices and electric apparatuses according to the present disclosure can also provide good heat dissipation performance.

According to an aspect of the present disclosure, there is provided an electrical device comprising: a semiconductor substrate having a power semiconductor device thereon, wherein a control electrode and a first current electrode of the power semiconductor device are arranged on a surface of the semiconductor substrate; a printed circuit board on which a driving module for driving the power semiconductor device is arranged, the driving module comprising at least one first switching element, and each of the first switching elements comprising a control terminal and current terminals; a first conductive piece disposed between the semiconductor substrate and the printed circuit board and used to provide an electrical connection to the first current electrode; one or more connecting members each of which passes through, and is electrically isolated from, the first conductive piece, and is connected to a part of the control electrode, and each being associated with a corresponding first switch element; and one or more first spring members, each of which is interposed between a corresponding connecting member and a first switching element associated with the corresponding connecting member, so that a first current terminal of the current terminals of each first switching element is electrically connected to a part of the control electrode through the connecting member.

According to another aspect of the present disclosure, there is provided an electrical device comprising: at least one first conductive piece each of which is provided with at least one recess; at least one elastic structure each of which is placed in a corresponding recess, an end of the elastic structure electrically connected to the first conductive piece; at least one switching element each of which is disposed in a corresponding recess, one electrode of the switching element coupled to the other end of the corresponding elastic structure disposed in the corresponding recess; a circuit board on a side of which the switching element is disposed, wherein at least one of other two electrodes of each of the switching elements is electrically connected to the circuit board; and at least one second conductive piece, the other side of the circuit board being attached to the at least one second conductive piece, wherein in the case that an external pressure that the electrical device is received is greater than a preset threshold, the first conductive piece each is electrically connected to the one electrode of the corresponding power semiconductor through a corresponding elastic structure.

According to a further aspect of the present disclosure, there is provided an electrical device comprising: at least one first conductive piece; at least one switching element each comprising a control electrode and current electrodes, wherein one of the current electrodes is disposed on a first surface of the switching element and is coupled to a corresponding first conductive piece, the other electrode of the current electrodes and the control electrode are disposed on a second surface of the switching element opposite to the first surface; at least one control electrode connecting member each comprising at least one conductive base and at least one elastic conductive structure received in the conductive base, wherein one end of each of the elastic conductive structures is coupled to a corresponding conductive base, and the other end of the elastic conductive structure is adapted to be coupled to a control electrode of a corresponding switching element to provide an electrical connection to the control electrode; at least one second conductive piece each comprising one or more raised portions, each of the raised portion being coupled to the other electrode of the current electrodes of a corresponding switching element.

According to a still further aspect of the present disclosure, there is provided an electrical device comprising: a power semiconductor device having a control electrode and current electrodes, the control electrodes being arranged in a ring form and disposed outside one of the current electrodes; a driving module for driving the power semiconductor device, the driving module comprising a plurality of switching elements which are divided into a plurality of groups; a plurality of first conductive members disposed on a side of the power semiconductor device, and used to respectively provide a connection of a corresponding switching element to the one of the current electrodes and a connection of a corresponding switching element to the control electrode, wherein at least one group of the plurality of groups of switching elements is electrically connected to the control electrode of the power semiconductor device; one or more conductive elastic structures, one end of each elastic structure being electrically connected to a corresponding first conductive piece, and the other end being electrically connected to a corresponding switching element.

According to a further aspect of the present disclosure, there is provided an electrical apparatus comprising the electrical device according to any aspects or embodiments of the present disclosure.

### BRIEF DESCRIPTION OF THE DRAWINGS

The accompanying drawings, which constitute a part of this specification, describe exemplary embodiments of the present disclosure and, together with the description, serve to explain principles of the present disclosure, in which:
FIG. 1 is a schematic circuit diagram showing an electrical device according to an embodiment of the present disclosure;
FIG. 2 is a schematic circuit diagram showing an electrical device according to an embodiment of the present disclosure;
FIG. 3 is a schematic structural diagram illustrating an electrical device according to an embodiment of the present application;
FIG. 4 is a schematic enlarged schematic diagram of a portion shown in FIG. 3 with dotted line;
FIG.5 illustrates a gate of a power semiconductor device in an electrical device according to an embodiment of the present application;
FIG. 6 illustrates a schematic diagram of switching elements arranged in a ring form in the electrical device shown in FIG. 3;
FIG. 7 illustrates a schematic diagram of a connecting member and an insulating member in the electrical device shown in FIG. 3;
FIG.8 is a schematic structural diagram illustrating an electrical device according to another embodiment of the present application;
FIG. 9 is a schematic diagram illustrating a channel for cooling provided in an electrical device according to an embodiment of the present application;
FIG. 10 illustrates a conventional press-pack MOSFET structure;
FIG. 11a illustrates a turn-off module of a gate driving circuit of an integrated gate commutated thyristor (IGCT);
FIG. 11b illustrates a drive circuit for an emitter-turn-off thyristor (ETO) based on the GCT or GTO device;
FIG. 12 is a schematic structural diagram illustrating a press-assembly structure according to an embodiment of the present disclosure;
FIG. 13 is a schematic diagram showing a spring structure of a press-assembly structure according to an embodiment of the present disclosure;
FIG.14 is a schematic diagram showing a structure of a circuit board of a press-assembly structure according to an embodiment of the present disclosure;
FIG. 15 is a diagram illustrating an array of press-pack MOSFETs arranged in a ring form according to an embodiment of the present disclosure;
FIG.16 is a schematic diagram illustrating an array of press-pack MOSFETs arranged in a plurality of rings according to an embodiment of the present disclosure;
FIG. 17 is a schematic diagram illustrating an array of press-pack MOSFETs arranged in a plurality of rings according to an embodiment of the present disclosure.
Fig. 18 is a cross-sectional view illustrating a structure of a MOSFET die (i.e., not packaged);
FIG.19 is a schematic diagram illustrating at least a part of an electrical device (or electrical structure) according to an embodiment of the present disclosure;
FIG. 20 is a schematic diagram illustrating at least a part of an electrical device (or electrical structure) according to an embodiment of the present disclosure;
FIG. 21 illustrates a gate connector for an array of press-pack MOSFETs arranged in ring form according to an embodiment of the present disclosure;
FIG. 22 is a schematic diagram showing an array of press-pack MOSFETs arranged in matrix according to an embodiment of the present disclosure;
FIG. 23 illustrates a schematic diagram of a gate connector for an array of press-pack MOSFETs arranged in matrix according to an embodiment of the present disclosure;
FIG. 24 is a schematic structural diagram illustrating an electrical device according to an embodiment of the present disclosure;
FIG. 25 is a schematic diagram illustrating an arrangement of power semiconductor devices in an electrical device according to an embodiment of the present disclosure;
FIG. 26 is a schematic diagram illustrating a ring arrangement of switching elements according to an embodiment of the present disclosure;
FIG. 27 is a schematic structural diagram illustrating an electrical device according to an embodiment of the present disclosure;
FIG. 28 is a schematic structural diagram illustrating another electrical device according to an embodiment of the present disclosure.

### DETAILED DESCRIPTION OF ILLUSTRATIVE EMBODIMENTS

Various exemplary embodiments of the present disclosure will be described in detail below with reference to the drawings. It should be understood, however, that the descriptions of the various embodiments are merely illustrative and are not intended to limit the inventions claimed in this application in any sense. The relative arrangement, expressions, and numerical values of the elements and steps of the exemplary embodiments shall not be deemed as limitations on the inventions to be claimed by the present application, unless specifically stated otherwise or explicitly or implicitly indicated by the context or principles thereof.

The terminology used herein is for the purpose of describing particular embodiments only and is not intended to limit the present disclosure. Unless the context clearly indicates otherwise, as used herein, the singular forms "a" and "the" are intended to include the plural forms as well. It is also to be understood that when the term "comprising" or "including" is used herein, it indicates the existence of the indicated features, wholes, steps, operations, units and/or components, but does not exclude the presence or addition of one or more of other features, wholes, steps, operations, units and/or components and/or combinations thereof.

In the present disclosure, the term "couple" or its variant is used to indicate a direct or indirect joint or connection between objects, including (but not limited to) mechanical and/or electrical coupling.

In the present disclosure, the term "electrical" is used to indicate that the object it defines refers to electricity; therefore, the term "electrical" may include the meaning of "electronic" or "electricity/power" or "power electronics". Therefore, the term "electrical" may also be replaced with "electronic" or "electricity/power" or "power electronics" when appropriate.

Terms such as "above" and "below" are used in this disclosure to indicate the positional relationship between objects. It should be understood, however, that such terms are merely descriptive and not restrictive, and that the present disclosure may also be implemented in an orientations other than those described herein.

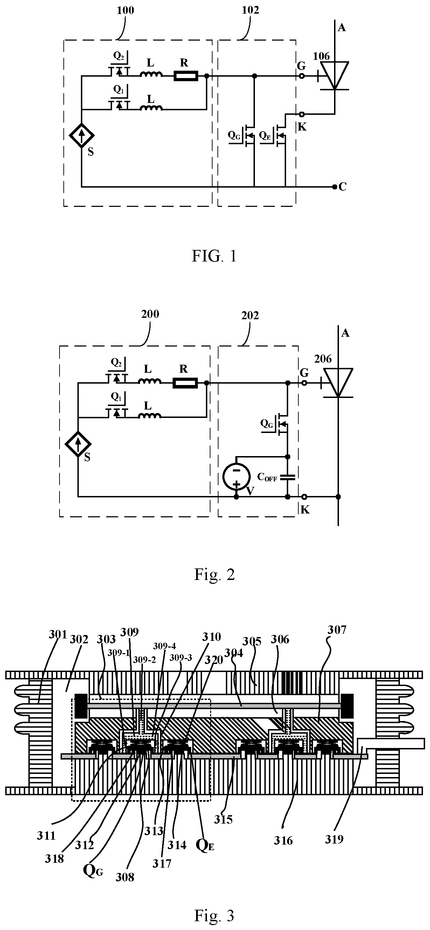

FIG. 1 illustrates a schematic circuit diagram of an electrical device according to an embodiment of the present disclosure. Specifically, as shown in FIG. 1, the electrical device may include a driving module and a power semiconductor device 106. The driving module can be used to drive the power semiconductor device 106 to perform a switching operation. The driving module may include a turn-off module 100 for turning off the power semiconductor device and/or a turn-on module 102 for turning on the power semiconductor device.

As an example, the turn-on module 100 may include a controllable current source which may include a voltage source S, an inductor L, a resistor R, and a plurality of switching elements Q1 and Q2, as shown in FIG. 1. As an example, the turn-off module 102 may include a plurality of switching elements Q_{G}, Q_{E}, as shown in FIG. 1.

In some embodiments, the switching elements (such as Q_{G}, Q_{E}) may comprise DirectFET™. DirectFET™ is a type of metal-oxide-semiconductor field effect transistor (MOSFET) produced and sold by the International Rectifier Company, which has a metal case connected to a current electrode (usually drain) of the MOSFET, and the case can be directly coupled to an external device (such as a PCB, etc.).

The power semiconductor device 106 may have a control terminal (G) and current terminals (A and K). Examples of the power semiconductor device 106 may include, but are not limited to, a gate commutated thyristor (GCT), a gate turn-off thyristor (GTO), and the like.

An electrical device which integrates gate commutated thyristor (GCT) or gate turn-off thyristor (GTO) and some or all of the electrical elements of the drive module can be called integrated gate commutated thyristor (IGCT) or emitter turn-off thyristor (ETO).

Below, description will be given taking an example in which a gate commutated thyristor (GCT) is used as the power semiconductor device 106. The gate commutated thyristor (GCT) may have a gate G as a control electrode (terminal) and an anode A and a cathode K as current electrodes (terminals) (or current carrying electrodes).

When the gate commutated thyristor (GCT) is to be turned on, the turn-on module 100 injects a current I to the gate G of the gate commutated thyristor (GCT) 106 to turn on the GCT. The injected current can be configured to have a higher current change rate (dl/dt) and a larger current amplitude, thereby ensuring even conduction of the power semiconductor device. At this time, the turn-off module 102 does not work.

When the gate commutated thyristor (GCT) is to be turned off, the turn-on module does not work, the switch Q_{G} of the turn-off module 102 is turned on, and the switch Q_{E} is turned off, and the current is communicated from the cathode K of the power semiconductor component to the gate G, to turn off the GCT.

FIG. 2 is a circuit diagram illustrating an electrical device according to another embodiment of the present disclosure. The electrical device shown in FIG. 2 includes a turn-on module 200, a turn-off module 202, a case, and a power semiconductor device 206. The electrical device shown in FIG. 2 is basically the same as that shown in FIG. 1 in the structures of the turn-on module and the power semiconductor device, except that the turned-off module 202. The turn-off module 202 shown in FIG. 2 may include a switching element Q_{G}, a capacitor C_{OFF}, and a voltage source V. The voltage source V can be used to pre-charge the capacitor C_{OFF}.

When the power semiconductor device 206 is to be turned on, the turn-off module does not work, and the turn-on module injects a large current I to the gate G of the power semiconductor device 206 to make the power semiconductor device 206 turn on. When the power semiconductor device 206 is to be turned off, the turn-on module does not work, and the switch Q_{G} is turned on, so that the current is commutated from the cathode K to the gate G through the pre-charged capacitor C_{OFF}, so that the power semiconductor device 206 is turned off.

In the circuit arrangement of a semiconductor device commonly used in the prior art, both the turn-on module and the turn-off module are outside the package (case) of the power semiconductor device, resulting in that the area of the commutation loop is large when the power semiconductor component is turned off, which in turn leads to a larger stray inductance in the commutation loop. Therefore, there is a need to improve the package structure of the semiconductor device and reduce the area of the commutation loop so as to reduce the stray inductance in the commutation loop.

It should be understood that the present disclosure shall not be limited to the driving modules and the manners in which the driving module is connected to the power semiconductor device shown in FIGS. 1 and 2.

Some embodiments of the present disclosure are described below with reference to FIGS. 3 to 5.

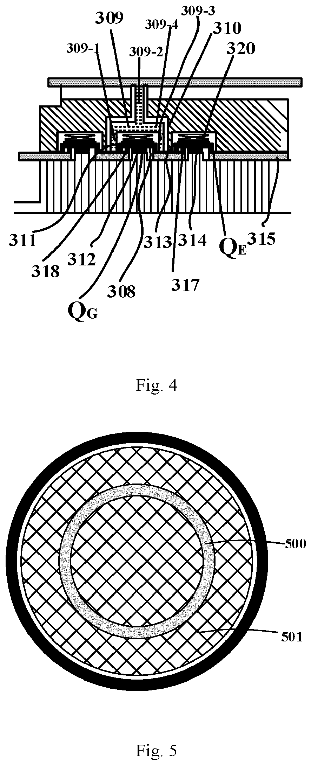

FIG. 3 is a schematic diagram illustrating a structure of an electrical device including a power semiconductor device according to an embodiment of the present application. For clarity, FIG. 4 illustrates an enlarged schematic diagram of a portion of FIG. 3 indicated with dotted line.

As shown in FIG. 3, the electrical device may include a power semiconductor device 304. Examples of the power semiconductor device 304 may include, but are not limited to, SCR, GCT, GTO, or the like. The power semiconductor device 304 may be formed in a semiconductor substrate. Therefore, in FIG. 3, 304 can also be used to indicate the semiconductor substrate. On a surface of the semiconductor substrate, a gate electrode (also referred to as a control electrode) and a current electrode (hereinafter also referred to as a first current electrode, such as the cathode K) 501 of the power semiconductor device 304 (see FIG. 5, not shown in FIG.3) are positioned.

The electrical device may further include a printed circuit board 315 on which a driving module for driving the power semiconductor device 304 may be arranged. The driving module may include a turn-off module for turning off the power semiconductor device 304 and/or a turn-on module for turning on the power semiconductor device 304, as described above with reference to FIGS. 1 and 2. The driving module may include at least one first switching element (e.g., Q_{G}). Those skilled in the art will readily understand that each first switching element may include a control terminal and current terminals.

In an embodiment, as shown in FIG. 3, the first switching element may include a drain terminal 311 and a source terminal 312 as current terminals (electrodes) and a gate terminal 318 as a control terminal (electrode). As an example, the drain terminal 311 and the gate terminal 318 of the first switching element may be electrically connected to the printed circuit board 315. In an embodiment, the drain terminal 311 and the gate terminal 318 may be coupled to the printed circuit board 315 by press-bonding, soldering, or other suitable bonding methods.

The electrical device may further include a first conductive piece 307. The first conductive piece 307 may be provided between the power semiconductor device 304 and the printed circuit board 315 for providing an electrical connection to a first current electrode 501 (which will be described in more detail later). Here, FIG. 3 also illustrates an optional conductive sheet 306 disposed between the power semiconductor device 304 and the conductive piece 307. In addition, although not shown here, insulating member(s) may be provided for the conductive members which are electrically connected to each other when needed, so as to, for example, provide an electrical connection of a specific geometry.

In an embodiment, the first conductive piece 307 may be used to provide an electrical connection to a cathode of the power semiconductor device 304. The first conductive piece 307 may be made of a conductive metal, and preferably the first conductive piece may be a metal copper piece. The first conductive piece 307 may be coupled to an electrode of the power semiconductor device 304 through press-bonding, thereby providing an electrical connection to the electrode.

In an embodiment, a conductive sheet 306 may be further provided between the first conductive piece 307 and the power semiconductor device 304 to be in direct contact with the first current electrode 501 of the power semiconductor component 304 and the conductive piece 307. Preferably, the conductive sheet 306 may comprise a conductive material having a thermal expansion coefficient consistent with the thermal expansion coefficient of the power semiconductor device 304, such as molybdenum for instance. The conductive sheet 306 can be used to reduce mechanical friction caused by the contact between the conductive piece and the power semiconductor device.

The electrical device may also include one or more connecting members 309. Each of the connecting members 309 may penetrate through, and be electrically isolated from, the first conductive piece 307, and be connected to a part of the gate electrode 500. In other words, the conductive piece 307 may have one or more openings penetrating therethrough to accommodate the corresponding connecting members 309 and the respective insulating members 310 that electrically isolate the connecting members 309 from the conductive piece 307. Each connecting member 309 may be associated with a corresponding first switching element.

The electrical device may also include one or more first spring members 308, such as butterfly springs. Each of the first spring members 308 may be placed between a connecting member 309 and a corresponding first switching element associated with the connecting member 309 such that a terminal (e.g., a first current terminal) of each first switching element may be electrically connected through the first spring member 308 and the connecting member 309 to a part of the gate electrode 500. In an embodiment, as shown in FIG. 3, the first current terminal may be the drain terminal 318 of the first switching element.

With the above-mentioned arrangement of the first spring member 308, it is possible to tightly couple the first switching element (such as Q_{G}) to a part of the gate electrode 500 through the connecting member 309 by means of press bonding, and avoid the power semiconductor device 304 (for example, to the semiconductor substrate thereof or electrodes on the semiconductor substrate) from being damaged due to a large mechanical pressure applied to the power semiconductor component 304, thereby improving reliability.

In the case of the power semiconductor device 304 with a large-capacity or high power (for example, with a size of 4 inches or 6 inches or more), a large pressure needs to be applied to the power semiconductor device 304 during the preparation process (for example, 36kN - 44kN to the device of 4-inch, 90kN - 130kN to the device of 6-inch) to achieve reliable contact between all cells of the power semiconductor device 304 and periphery components, thereby reducing contact resistance. The arrangement shown in Figure 3 is more advantageous in such a case.

In addition, with the above-mentioned arrangement, the turn-off module shown in FIG. 1 and FIG. 2 is integrated along with the power semiconductor device in the housing case (i.e., the package), which can significantly reduce the area of the commutation loop inside the semiconductor device. Thus, the stray inductance in the commutation circuit can be effectively reduced, thereby increasing the commutation speed and improving the turn-off reliability.

FIG. 5 illustrates a schematic top view of a power semiconductor device in an electrical device according to an embodiment of the present application. A gate electrode 500 and a first current electrode 501 may be arranged on a surface (for example, the lower surface) of a semiconductor substrate of the power semiconductor device 304. Preferably, the first current electrode 501 may be provided to surround the gate electrode 500. In an embodiment, the gate electrodes 500 may be arranged in a ring form on the semiconductor substrate. Inside the gate electrode 500, a part of the first current electrode 501 may be provided, and outside of the gate electrode 500, another part of the first current electrode 501 may be provided. In an embodiment, the first current electrode 501 may be a cathode of the power semiconductor device 304. Although FIG. 5 here only illustrates the case where the gate electrode 500 is arranged in a continuous circular ring form on the semiconductor substrate, it should be understood that the gate electrode 500 can also be arranged on the semiconductor substrate in a continuous or discontinuous ring of any appropriate shapes, such as oval ring, square ring, regular polygonal ring, irregular polygonal rings, etc.

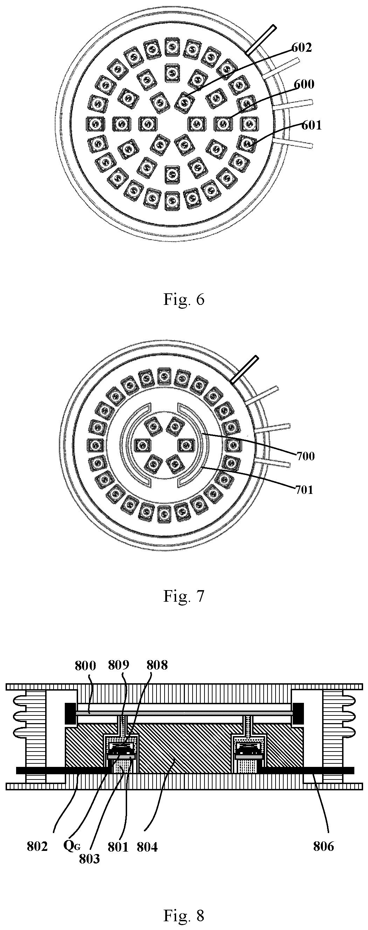

FIG. 6 is a schematic diagram showing an arrangement of a switching element according to an embodiment of the present disclosure. In an embodiment, as shown in FIG. 6, at least one switching element may be disposed on the printed circuit board 315 in an annularly distributed arrangement. FIG. 6 illustrates a first plurality of switching elements 600, a second plurality of switching elements 601, and a third plurality of switching elements 602 which are, respectively, arranged in an approximately concentric rings. In an embodiment, the first plurality of switching elements 600 may correspond to the switch Q_{G} in the turn-off module 102 in the driving module shown in FIG. 1, and the second plurality of switching elements 601 and the third plurality of switching elements 602 may correspond to the switch Q_{E} in the turn-off module 102 in the driving module shown in FIG. 1. Although FIG. 6 here illustrates that the switching elements are arranged on the semiconductor substrate in a circular ring form, it should be understood that the first switching element may be arranged on the semiconductor substrate in a ring form of any other shape, such as oval, square, polygons, etc.

FIG. 7 illustrates a schematic top view of a portion of an electrical device according to another embodiment of the present disclosure. An upper surface 700 of the connecting member 309 which is illustrated as separate arc shapes, and an upper surface 701 of an insulating member 310 surrounding the connecting member 309 are shown in FIG. 7. FIG. 7 also illustrates a switching element, such as the switch Q_{E}, provided on the printed circuit board 315.

With such an arrangement as described above, it is possible to tightly couple the switching element (such as Q_{G}) to the electrode of the power component by press-fitting or press-bonding to provide a reliable connection, and further reduce the possibility that the power semiconductor device 304 (for example, its semiconductor substrate or the electrodes on the semiconductor substrate) is damaged due to the mechanical press applied to the power semiconductor component 304. In addition, contact resistance and stray inductance can also be reduced, thereby increasing the commutation speed and improving the turn-off reliability.

Returning to FIG. 3, in an embodiment, the electrical device may further include a second conductive piece (also referred to as a negative-electrode conductive piece in some embodiments) 316. The conductive piece 316 may be coupled to the printed circuit board 315 by press-bonding, and more specifically, to a conductive member (for example, a conductive pad or an electrode) on the printed circuit board 315 to provide electrical connection to the printed circuit board. In the embodiment shown in FIG. 3, the printed circuit board 315 is shown as being disposed between the negative-electrode conductive piece 316 and the first conductive piece 307. Although not shown in the figure, it is to be understood that when needed, a piece (or shim) or a suitable insulating member may also be present between the conductive piece 316 and the printed circuit board.

In an embodiment, the conductive piece 316 is further configured to be in close contact with the source terminal 312 of the switching element to provide an electrical connection to the source terminal 312. As shown in FIG. 3, by providing protrusions at corresponding positions of the negative-electrode conductive piece 316, the source terminals 312 and the negative electrode conductive piece 316 can be brought into close contact.

In an embodiment, as shown in FIG. 3, the first conductive piece 307 may comprise a first opening penetrating therethrough, the first opening is adapted to receive the corresponding connecting member 309, the corresponding first switching element, and the corresponding first spring member 308 therein. In an embodiment, as shown in FIG. 3, the connecting member 309 may include a protruding first portion 309-2 and a recessed second portion 309-4. A lateral dimension of the first portion 309-2 may be smaller than the lateral dimension of the second portion 309-4. A corresponding switching element and a corresponding spring member 308 are housed in the second portion 309-4. The second portion may include side arms 309-1 and 309-3 arranged near the edges of the recess and extending to the printed circuit board 315. The side arms 309-1 and 309-3 may also be engaged with the printed circuit board 315 by press-bonding to provide an electrical connection therebetween. The side arms 309-1 and 309-3 and the first portion 309-2 may be configured to be substantially perpendicular to the semiconductor substrate of the power semiconductor component 304 and the printed circuit board 315, as shown in FIGS. 3 and 4.

With the side arms 309-1 and 309-3, the connecting member 309 can electrically connect the gate electrode 500 or a part thereof to the printed circuit board 315. In this way, the gate electrode 500 or a part thereof may be connected to the first current terminal of the switch Q_{G} on the printed circuit board 315 through the first spring member 308 and the connecting member 309, and the gate electrode 500 or the part thereof may also be connected to a connection site on the printed circuit board 315 (which is substantially equipotential to the first current terminal) through the side arms 309-1 and 309-3, so that there are separate redundant current paths between the potential of the first current terminal of the switch Q_{G} and the gate electrode 500 s, thus the current-conducting capacity can be increased and redundant current paths can be provided, which improves reliability.

In an embodiment, the first spring member 308 may be a disc spring. However, it should be understood that the first spring member 308 may adopt a conductive member of any shape capable of generating a suitable elastic force, comprising, but not limited to, any suitable spring such as a disc spring, a compression spring, etc. as described above.

As mentioned above, the electrical device may further include one or more second switching elements (such as Q_{E}). The second switching element Q_{E} may be placed on the same surface of the printed circuit board 315 as the first switching element. The electrical device may further include one or more second spring members 320. Each second spring member 320 may be disposed between a corresponding second switching element Q_{E} and the first conductive piece 307, so that the second switching element Q_{E} is electrically connected to an electrode (for example, the first current electrode 501) of the power semiconductor device 304 through the first conductive piece 307. Specifically, in an embodiment, the first current electrode 500 may be the cathode of the power semiconductor device 304. With the second spring member 320, the cathode of the power semiconductor device 304 and the second switching element Q_{E} may be connected via the first conductive piece 307.

The second spring member 320 may be a disc spring. However, it should be understood that the second spring member 320 may adopt an elastic conductive member of any shape capable of generating a suitable elastic force, including but not limited to springs.

In some embodiments, similar to the first switching element, the second switching element Q_{E} may include a drain terminal 313, a source terminal 314, and a gate terminal 317. Through the second spring member 320 and the first conductive piece 307, the drain terminal 313 of the second switching element Q_{E} can be electrically connected to the first current electrode 501 of the power semiconductor device 304.

The plurality of second switching elements Q_{E} may also be arranged on the printed circuit board 315 in an annular distribution. Preferably, as shown in FIGS. 3 and 6, two second switching elements Q_{E} may be arranged symmetrically at both sides of at least a portion of the first switching elements 600, respectively, in a radial direction. Specifically, in an embodiment, as shown in FIG. 6, a plurality of first switching elements may be arranged in a first ring 600, and a second ring 601 and a third ring 602 formed of a plurality of second switching elements Q_{E} are arranged outside and inside the first ring 600, respectively. For a part or all of the first switching elements in the first ring 600, a corresponding second switching element Q_{E} may be arranged on each side of a first switching element in the radial direction of the first ring 600. Preferably, the distances between the first switching element and the respective second switching elements Q_{E} on both sides may be set to be substantially equal. In some embodiments, through the symmetrical arrangement of the second switching elements Q_{E}, the areas of the commutation loops between the gate of the power semiconductor device 304 and the cathodes thereof at different positions can be made substantially the same, so that the commutation speed of different communication loops are basically the same. Therefore, the cells at different positions inside the power semiconductor device 304 can be uniformly turned off, preventing such a case that one or some cells would otherwise generate excessive heat, thereby preventing damage to the power semiconductor device 304.

By using such an arrangement of the second spring member 320, the second switching element Q_{E} can be tightly coupled to the first current electrode 501 through the first conductive piece 307, but without excessive pressure applied to the power semiconductor device 304 from outside to damage the power semiconductor component 304. In the case of a large-capacity or high-power power semiconductor device 304 (for example, a power semiconductor device 304 having a size of 4 inches or 6 inches), a larger pressure may need to be applied (for example, for 4-inch, 36kN - 44kN may be required, and for 6-inch , for example, 90kN - 110 kN may be required), thus the arrangement of the second spring member 520 is more advantageous.

With such an arrangement as described above, it is possible to tightly couple the switching elements (such as Q_{G}, Q_{E}) and the electrodes of the power element through pressure fitting or press-bonding to provide a reliable connection, and further reduce possibility that the power semiconductor device (such as its semiconductor substrate or electrodes on the semiconductor substrate) is damaged due to the mechanical pressure applied to the power semiconductor component. In addition, the contact resistance and stray inductance can also be reduced, thereby increasing the commutation speed and improving the turn-off reliability.

Returning again to FIG. 3, the electrical device may further include a coaxial cable 319 connecting the printed circuit board 315 to the outside. In an embodiment, the coaxial cable 319 may provide connections between the external and the gate terminals and/or source terminals of the first switching element and/or the second switching element Q_{E}, respectively, so as to control the switches Q_{G} and/or Q_{E} to be turned on and off. Alternatively, the coaxial cable 319 may provide connections from the external to the gate electrode 500 and/or the first current electrode 501 of the power semiconductor device 304, respectively, so as to control the power semiconductor device 304 to be turned on or off. Alternatively, the coaxial cable 319 can be used to measure the currents flowing through the switching elements (for example, Q_{G} and/or Q_{E}, Q1 and/or Q2, etc.), thereby protecting the switching elements from overcurrent.

As shown in FIG. 3, the electrical device may further include a third conductive piece 305, and the third conductive piece 305 may be used to provide electrical connection to a third current electrode of the power semiconductor device 304 disposed on the other surface of the semiconductor substrate. In an embodiment, the third current electrode may be an anode of the power semiconductor device 304, and the anode may be located on an upper surface of the semiconductor substrate. As shown in FIG. 3, a conductive piece 303 may be provided between the third conductive piece 305 and the power semiconductor device 304 to be in direct contact with the third current electrode of the power semiconductor device 304. The conductive piece 303 may comprise a conductive material with a thermal expansion coefficient consistent with the thermal expansion coefficient of the semiconductor device 304, such as molybdenum, and is used to improve the bonding between the third conductive piece 305 and the power semiconductor device 304, and to reduce the mechanical friction caused by the contact between the conductive piece and the power semiconductor device.

The electrical device may further include a package case, which may encapsulate the power semiconductor device 304 and the driving module together with the second conductive piece 316 and the third conductive piece 305. Specifically, the package case may include a support 301. Each of the third conductive piece 305 and the second conductive piece 316 may have an extension portion extending from a side thereof. The support 301 may be disposed between the extensions of the third conductive piece 305 and the second conductive piece 316 to form a cavity 302. The power semiconductor device 304, the printed circuit board 315, and the like may be disposed in the cavity 202. The support 301 may be formed of ceramic. In an embodiment, protrusion(s) (also referred to as an umbrella skirt structure) may be provided on the outer side of the support 301, as shown in FIG. 3, in order to increase the creepage distance and improve the insulation performance. In an embodiment, the sealed cavity 302 may be filled with a gas that is stable in nature and not easily decomposed, such as nitrogen, helium, etc., thereby further protecting the power semiconductor device 304 from being affected by the external environment. The support 301 may further be provided with an opening for passing through the coaxial cable 319.

In an embodiment, the power semiconductor device 304 may include a gate commutated thyristor (GCT) or a gate turn-off thyristor (GTO). In an embodiment, the electrical device shown in FIG. 3 may constitute an emitter turn-off thyristor (ETO).

Reference is now made to FIG. 8. FIG. 8 is a schematic structural diagram of an electrical device comprising a semiconductor device according to another embodiment of the present application. Similar to FIG. 3, the electrical device may include a power semiconductor device 800, a printed circuit board 801, a driving module disposed on the printed circuit board 801 and including one or more first switching elements, a first conductive piece 804, one or more first spring members 808 and one or more connecting members 809. The embodiment shown in FIG. 8 is different from the embodiment shown in FIG. 3 in that:
the printed circuit board 801 is disposed in an opening in the first conductive piece 804; the gate terminal(s), the source terminal(s), and the drain terminal(s) can be electrically connected to the printed circuit board 801 by soldering or other available electrical connection methods; and the driving module arranged on the printed circuit board 801 can further include capacitor(s) 803 attached to the printed circuit board 801 (shown as to a lower surface of 801 in the figure). In an embodiment, the capacitor(s) 803 may be electrically connected to the first switching element(s) through the printed circuit board 801.

Because the power semiconductor device 800, the first conductive piece 804, the first switching elements, the first spring members 808, the connecting members 809, the coaxial cables 802 and 806, and other components which might not be labeled in FIG. 8 are basically the same as the corresponding components in FIG. 3, those will not be repeatedly described here. The description made in connection with FIG. 3 can be readily applied to this embodiment.

In an embodiment, the power semiconductor device 800 may include GCT or GTO, and the electrical device shown in FIG. 8 may constitute an integrated gate commutated thyristor (IGCT).

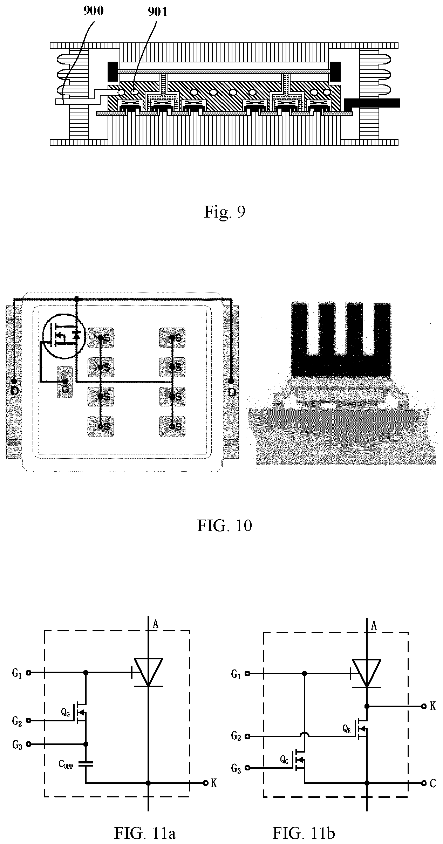

FIG. 9 illustrates a schematic diagram of an electrical device according to an embodiment of the present application. As shown in FIG. 9, preferably, the first conductive piece may be provided with channels 900 and 901 for cooling. In some embodiments, in the case of using a fluid for cooling, the channel 900 may be a pipe communicating with the external and transporting a fluid in and out, and the channel 901 may be a fluid channel in the first conductive piece. Because for a semiconductor power apparatus, the main heat-generating part of a semiconductor apparatus is the power semiconductor device 304, and the printed circuit board 315 usually uses a material with poor thermal conductivity, the heat is easily accumulated in the first conductive piece, and thus the first conductive piece provided with channel for cooling can effectively improve the heat dissipation performance of the entire semiconductor apparatus. In addition, although the cooling channels 901 are shown as being provided in the first conductive piece in the embodiment shown in FIG. 9, the present disclosure is not limited thereto. Where appropriate, the cooling channels may be provided in or on other conductive piece(s). Preferably, the cooling fluid is non-conductive. In the case of using a fluid that may be conductive such as water, it is preferable to use deionized water, or to provide an insulation layer in the cooling channel to provide insulation.

According to this aspect of the present disclosure, the following embodiments are also provided.

There is provided an electrical device comprising: a semiconductor substrate having a power semiconductor device thereon, wherein a control electrode and a first current electrode of the power semiconductor device are arranged on a surface of the semiconductor substrate; a printed circuit board on which a driving module for driving the power semiconductor device is arranged, the driving module comprising at least one first switching element, and each of the first switching elements comprising a control terminal and current terminals; a first conductive piece disposed between the semiconductor substrate and the printed circuit board and used to provide an electrical connection to the first current electrode; one or more connecting members each of which passes through, and is electrically isolated from, the first conductive piece, and is connected to a part of the control electrode, and each being associated with a corresponding first switch element; and one or more first spring members, each of which is interposed between a corresponding connecting member and a first switching element associated with the corresponding connecting member, so that a first current terminal of the current terminals of each first switching element is electrically connected to a part of the control electrode through the connecting member.

In an embodiment, the control electrode is arranged in a ring form on the semiconductor substrate.

In an embodiment, the at least one first switching element comprises a plurality of the first switching elements, the plurality of first switching elements are divided into a plurality of groups, wherein at least one group corresponds the control electrode of the power semiconductor device.

In an embodiment, each of the first switching elements comprise a drain terminal and a source terminal as the current terminals and a gate terminal as the control terminal, and a second current terminal and the gate terminal of the first switching element are coupled to the printed circuit board, wherein a first current terminal is one of the drain terminal and the source terminal, and the second current terminal is the other of the drain terminal and the source terminal.

In an embodiment, the first spring member is one of: a conductive spring; and a conductive elastic structure comprising a spring and a conductive member.

In an embodiment, the first conductive piece comprises a first opening therethrough, and the first opening is adapted to receive therein a corresponding connecting member, a corresponding first switching element, and a corresponding first spring member.

In an embodiment, the connecting member has a protruding first portion and a recessed second portion, a lateral dimension of the first portion being less than that of the second portion, wherein a corresponding first switching element and a corresponding first spring member are received in the second portion, and the recess comprises a side arm disposed at an edge of the recess and extending to the printed circuit board.

In an embodiment, the electrical device further comprises an insulating member arranged between the connecting member and the first conductive piece to insulate them from each other.

In an embodiment, the first switching elements in each of the groups are arranged in one of the following forms: ring(s), part of ring(s), or a matrix.

In an embodiment, the electrical device further comprises: one or more second switching elements placed on the same surface of the printed circuit board as the first switching element, and one or more second spring members each of which is disposed between a corresponding second switching element and the first conductive piece, so that the second switching elements are electrically connected to the first current electrode of the power semiconductor device through the first conductive piece, wherein the second switching elements and the second spring members are disposed in recesses of the conductive piece.

In an embodiment, the plurality of second switching elements are distributed in a ring arrangement on the printed circuit board, and a second switching element is arranged on each of both sides of at least a portion of the first switching elements symmetrically in a radial direction of the ring.

In an embodiment, a channel for cooling is provided in the first conductive piece.

In an embodiment, the first switching elements comprise DirectFETs, and the power semiconductor device comprises a Gate Commutated Thyristor (GCT) or a Gate Turn-off Thyristor (GTO).

In an embodiment, the electrical device further comprises: a second conductive piece coupled to the other side of the printed circuit board; a third conductive piece coupled to a second current electrode of the power semiconductor device that is disposed on the other surface of the semiconductor substrate; and a package case which, together with the second conductive piece and the third conductive piece, encapsulates the power semiconductor device and the driving module.

Blow, description will be given in connection with another aspect of the present disclosure.

Traditionally, MOSFETs used in power applications generally have a lateral current-conducting structure. The gate, drain, and source are usually soldered to a circuit board, and the heat generated during device operation is mainly dissipated through the circuit board. Affected by the type of package, this MOSFET has a poor heat dissipation capability, which limits its current-conducting capacity. Therefore, a press-pack MOSFET is proposed, as shown in FIG. 10, which has a vertical current-conducting structure, the drain electrode is connected to the top metal case, and the source electrode and the gate electrode are disposed at the bottom. In use, the bottom source and gate electrodes can be soldered to the circuit board, the left and right drain electrodes are soldered to the circuit board, and the top drain electrode is press-bonded to a metal connection structure to increase heat dissipation capability.

In high-power applications, usually a large number of MOSFETs are used to be connected in parallel to form an array to achieve function of turning on and off high-currents. For example, as shown in Figure 11 (a), a turn-off module that integrates the gate drive circuit for a gate commutated thyristor (IGCT) employs an array of large number of parallel MOSFET, Q_{G}, and a group of parallel capacitors, Coff, which are connected in series, and in order to turn off the IGCT, the MOSFET array Q_{G} is triggered to be turned on so that the cathode current of the IGCT is commutated to the gate electrode, thereby turning off the IGCT. As another example, as shown in FIG. 11 (b), a driving circuit of an emitter turn-off thyristor (ETO) based on GCT or GTO device uses two parallel MOSFET arrays Q_{G} and Q_{E}. When ETO is turned on, Q_{G} is turned off and Q_{E} is turned on; when ETO is turned off, Q_{E} is turned off and Q_{G} is turned on, and current is commutated from the cathode of the GCT or GTO device to the gate electrode, thereby turning it off.

In most of the existing MOSFET arrays, traditionally MOSFETs are soldered to the circuit board. Due to the limited current-conducting capacity of a single MOSFET, a large number of MOSFETs are connected in parallel in high-power applications. If a press-pack MOSFET is used, the number of the device connected in parallel can be greatly reduced, but since its heat dissipation manner is special, at present, there is no any specific heat-dissipation structure for the press-pack MOSFET array. In addition, in some applications which employs IGCT or ETO drive circuits, in order to increase the communication speed of the current of the device to be turned off from the cathode to the gate, the stray inductance of the loop is to be reduced as much as possible; for this sake, it may be desirable to integrate the MOSFETs in a device package case. However, when using GCT or GTO, it may need to press-bond molybdenum sheets to both sides thereof and apply a pressure of more than tens of kN, however a single press-pack MOSFET may only withstand a pressure of 50-100N, thus for integrating such MOSFET into a package, there may be pressure differences and coordination problems of different components.

For addressing one or more of the above problems, a press-assembly structure according to an aspect of the present disclosure is proposed.

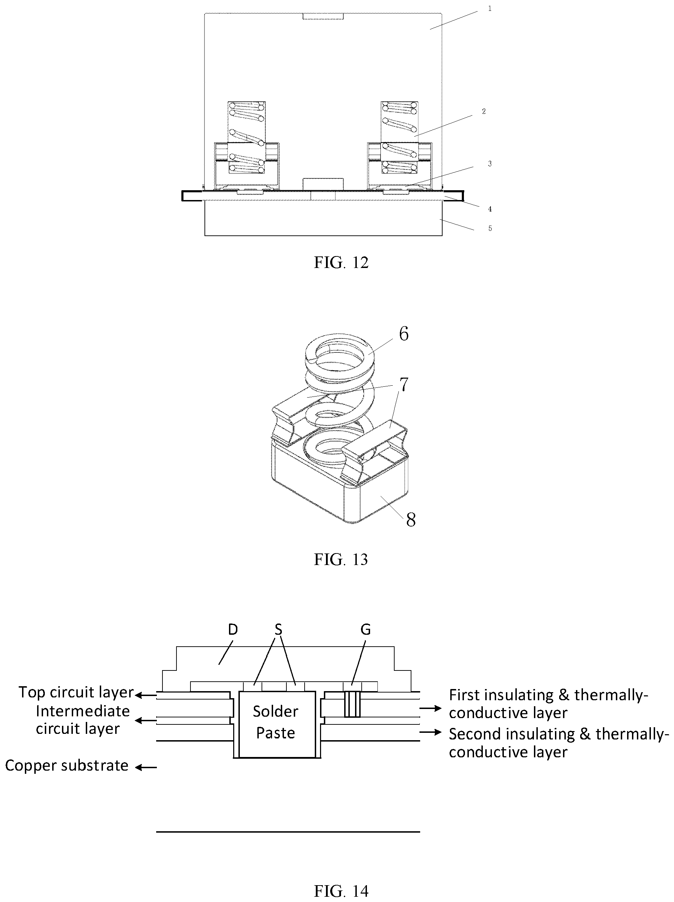

In an embodiment, a press-assembly structure for a power semiconductor device (for example, a press-pack MOSFET) is provided. It should be understood that the press-assembly structure can be regarded as an electrical device. As shown in FIG. 12, the press-assembly structure includes, from top to bottom, a first conductive piece (for example, a copper piece) 1, an elastic structure 2, a press-pack MOSFET 3, a circuit board 4, and a second conductive piece (for example, a copper piece) 5. The bottom of the first copper piece 1 is provided with a recess, and the elastic structure 2 and the press-pack MOSFET 3 are placed in the recess. The press-assembly structure may include one or more elastic structures 2 and one or more press-pack MOSFETs 3. In some embodiments, the elastic structures 2 correspond to the press-pack MOSFETs 3 in a one-to-one manner, but the present disclosure is not limited thereto. One or more recesses are provided at the bottom of the first copper piece 1. The elastic structures 2 and the corresponding press-pack MOSFETs 3 are disposed in the corresponding recesses. The press-assembly structure may have multiple sets of elastic structures 2 and corresponding arrays of press-contact type MOSFETs 3. It should be understood that although press-pack MOSFET is taken as an example here, those skilled in the art will readily understand that any suitable power semiconductor device may be used in place of the press-pack MOSFET.

In some embodiments, the spring structure 2, as shown in FIG. 13, includes: a main spring 6, conductive auxiliary elastic pieces 7 (two in the example of FIG. 13), and a metal base 8. The metal base 8 has a recess structure. The main spring 6 is preferably conductive. One end of the main spring 6 and the metal base 8 are disposed in the recess and coupled to the bottom of the recess so as to be coupled to the metal base 8. One end of the auxiliary elastic piece 7 is coupled to the metal base 8. The other end of the main spring 6 is coupled to the bottom recess of the first copper piece 1. When there is no external pressure or the external pressure is less than or equal to a predetermined threshold value, the other ends of the two auxiliary elastic pieces 7 do not contact, or just slightly contact, the bottom of the corresponding recess of the first copper piece 1. When the external pressure is greater than the preset threshold, the other ends of the auxiliary elastic pieces are in contact with the corresponding first conductive piece. The auxiliary elastic pieces may generate an elastic force in a direction opposite to a direction in which the other end receives the force.

The circuit board 4 may include a substrate. For example, the substrate may be an FR4 substrate, an aluminum-based substrate or a copper-based substrate. Those skilled in the art will readily understand that the term "FR4 substrate" refers to the substrates that comply with the FR4 standard. In an embodiment, as shown in FIG. 14, the circuit board 4 includes a top circuit layer, a first insulating and thermally conductive layer, an intermediate circuit layer, a second insulating and thermally conductive layer, and a copper substrate. A second insulating and thermally conductive layer is disposed between the substrate and the intermediate circuit layer, the intermediate circuit layer is disposed between the first insulating and thermally conductive layer and the second insulating and thermally conductive layer, and the first insulating and thermally conductive layer is disposed between the top circuit layer and the intermediate circuit layer.

Referring back to FIG. 12, as shown in FIG. 12, the elastic structure 2 and the corresponding press-pack MOSFET 3 are disposed in a recess at the bottom of the first copper piece 1. The top of the elastic structure 2 is electrically connected to the inner surface of the recess. When no pressure is applied, the first copper piece 1 is not in contact with the circuit board 4, and the first copper piece 1 is only electrically connected to a current electrode (for example, the drain electrode) of the press-pack MOSFET 3 through the elastic structure 2. The metal base 8 at the bottom of the elastic structure 2 is coupled to the top of the press-pack MOSFET 3. In some embodiments, an current electrode (e.g., a drain electrode) of the press-pack MOSFET 3 is provided on the top or is electrically connected to the top of the case. Another current electrode (for example, a source electrode) and a control electrode (for example, a gate electrode) at the bottom of the press-pack MOSFET 3 are electrically connected to the circuit board 4. The press-pack MOSFET 3 is disposed on the circuit board 4. In some embodiments, the second copper piece 5 may be rigidly coupled to the underside of the circuit board 4, for example, coupled to the substrate of the circuit board. It should be understood that the present disclosure is not limited thereto.

In an embodiment, when the pressure applied between the first copper piece 1 and the second copper piece 5 is small (for example, less than or equal to a predetermined threshold), the elastic structure 2 deforms less, and the first copper piece 1 and the circuit board 4 do not contact, and the first copper piece 1 is electrically connected to the drain electrode of the press-pack MOSFET 3 only through the elastic structure 2. The auxiliary elastic piece 7 in the elastic structure 2 may be configured to slightly contact or not contact with the first copper piece in this case. The auxiliary elastic piece 7 in the elastic structure 2 is used to increase the current-conducting area and contact area, and reduce the electric resistance and thermal resistance.

When the pressure applied between the first copper piece 1 and the second copper piece 5 is large (for example, greater than a threshold value), the deformation of the elastic structure 2 is relative large, and the first copper piece 1 is in contact with the circuit board 4. In this way, the first copper piece 1 can be electrically connected to the drain electrode of the press-pack MOSFET 3 through the elastic structure 2, and can be electrically connected to the drain electrode of the press-pack MOSFET 3 through the contact surface of the first copper piece 1 and the circuit board 4, and through the copper-plated (wiring) area of the top circuit layer of the circuit board 4. Therefore, the current-conducting area of the first copper piece 1 and the drain electrode of the press-pack MOSFET 3 can be increased, and the electric resistance can be reduced. In addition, in this case, the other ends of the auxiliary elastic pieces 7 in the elastic structure 2 are in contact with the corresponding first conductive piece, and the auxiliary elastic pieces generate an elastic force in a direction opposite to the direction in which the other end receives the force. In this way, a reliable electrical connection can be guaranteed. In addition, the auxiliary elastic pieces 7 in the elastic structure 2 can increase the current-conducting area and contact area, and reduce the electric resistance and thermal resistance.

The bottom of the metal base 8 of the elastic structure 2 is coupled to the drain electrode on the top of the press-pack MOSFET 3. The main spring 6 is used to provide pressure on the contact surface so as to reduce contact resistance and thermal resistance.

As shown in FIG. 14, the edge of the metal case connected to the drain electrode D of the press-pack MOSFET 3 is coupled to the top circuit layer of the circuit board 4. The gate electrode G of the press-pack MOSFET 3 is coupled to the intermediate circuit layer of the circuit board 4 through a via hole, and can be connected to a gate trigger signal receiving terminal of the circuit board. The source electrode S of the press-pack MOSFET 3 is coupled to the copper substrate of the circuit board 4 through a conductive and thermally conductive member (for example, a conductive medium such as a solder paste; or a conductive piece such as a copper piece). It should be understood here that the substrate of the circuit board 4 may be a conductive substrate or an insulating substrate. Those skilled in the art may configure that there is, or there is no, electrical connection provided between the circuit board 4 and the second conductive piece (copper piece) 5 as required, and may also set other different electrical connection manners.

In some embodiments, the second copper piece 5 may be electrically connected to the source electrode of the press-pack MOSFET 3 through the circuit board 4.

According to the press-assembly structure of the embodiment of the present disclosure, various pressures can be applied between the top end of the first copper piece 1 and the bottom end of the second copper piece 5 as required by different applications; for example, it can be as high as several tens of kN. In some embodiments, an external pressure greater than the predetermined threshold is maintained between the first conductive piece and the second conductive piece. In this way, a reliable electrical connection can be ensured.

In some embodiments, when the pressure applied between the first copper piece 1 and the second copper piece 5 is small, the elastic structure 2 is deformed less, the first copper piece 1 is not in contact with the circuit board 4, and the second copper piece 5 is in rigid contact with the circuit board. In such a case, the pressure applied between the first copper piece 1 and the second copper piece 5 is the sum of the pressures of the press-pack MOSFET 3 array and the metal base 8.

In some embodiments, when pressure is increased between the first copper piece 1 and the second copper piece 5, the first copper piece 1 is rigidly contacted with the circuit board 4, and the second copper piece 5 is rigidly contacted with the circuit board 4, at this time the spring deformation no longer increases. Therefore, the parameters of the main spring 6 can be designed according to the pressure requirement (50-100N) of the press-bonded MOSFET 3 and the metal base 8 of the elastic structure 2, so that the main spring 6 can provide the required pressure value at the maximum deformation. When the pressure continues to increase, excess pressure will be applied to the contact surface between the first copper piece 1 and the circuit board 4 to prevent the press-pack MOSFET 3 from being damaged by mechanical stress due to excessive pressure.

According to the press-assembly structure of the embodiment of the present disclosure, the heat, which is generated by the press-pack MOSFET 3 when current is conducted therethrough, can be dissipated through the upper and lower surfaces. In the direction to the upper surface, heat is dissipated through the metal base 8, the auxiliary elastic piece 7, the first copper piece 1, and a heat sink connected to the first copper piece 1. In addition, heat can also be dissipated through both ends of the drain electrode D metal case, the top circuit layer of the circuit board 4, the first copper piece 1, and the heat sink connected to the first copper piece 1. In the direction to the lower surface, heat can be dissipated through the solder paste, the copper substrate, the second copper piece 5, and a heat sink connected to the second copper piece 5. Thus, double-sided heat dissipation can be achieved, and heat dissipation can be improved.

The pressure applied between the first copper piece 1 and the second copper piece 5 is advantageous to improving the contact of each contact surface, reducing the thermal resistance and contact resistance of each contact surface, thereby enhancing the heat conduction capacity and the current-conducting capacity.

In an embodiment, the at least one power semiconductor device includes a plurality of power semiconductor devices, and the plurality of power semiconductor devices are divided into a plurality of groups. One electrode of each of the power semiconductor devices in each group is electrically connected together. The at least one first conductive piece includes a plurality of first conductive pieces, and each first conductive piece corresponds to a group, and each power semiconductor device in the corresponding group is disposed in a corresponding recess in the first conductive piece. The electrical device further includes a first insulating isolation structure disposed between the conductive pieces corresponding to two adjacent groups.

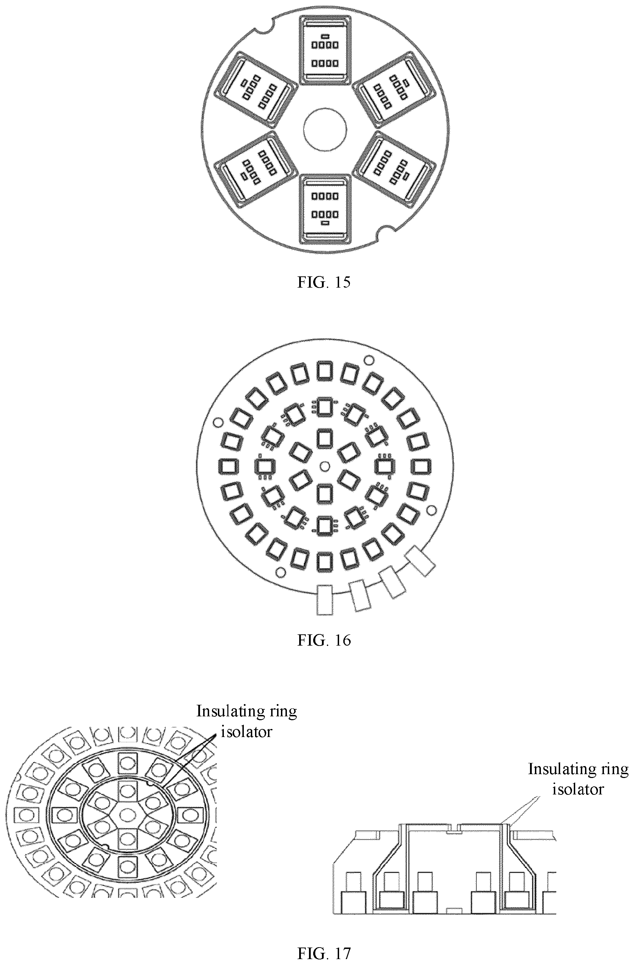

In a specific embodiment, at least some of the array of press-pack MOSFETs may be arranged in a ring form. To form a ring as shown in FIG. 15; or to form multiple rings, for example, form three rings as shown in FIG. 15; or to be arranged in a matrix. In some embodiments, a set of press-pack MOSFETs can also be arranged as a part of a ring.

The first copper piece, the second copper piece, and the elastic structure can be designed according to the arrangement of array(s) of the press-pack MOSFETs. For the distribution shown in Fig. 16, if the drain electrodes of the press-pack MOSFETs in different rings have different potentials, multiple first copper pieces can be designed and provided, and an insulating ring barrier layer can be additionally provided between the different first copper pieces, as shown in FIG. 17. If the source electrodes of the press-pack MOSFETs in different loops have different potentials, for the same reason, multiple second copper pieces can be designed and provided.

So far, it should also be understood that this aspect of the present disclosure also provides the following embodiments.

There is provided an electrical device comprising: at least one first conductive piece each of which is provided with at least one recess; at least one elastic structure each of which is placed in a corresponding recess, an end of the elastic structure electrically connected to the first conductive piece; at least one switching element each of which is disposed in a corresponding recess, one electrode of the switching element coupled to the other end of the corresponding elastic structure disposed in the corresponding recess; a circuit board on a side of which the switching element is disposed, wherein at least one of other two electrodes of each of the switching elements is electrically connected to the circuit board; and at least one second conductive piece, the other side of the circuit board being attached to the at least one second conductive piece, wherein in the case that an external pressure that the electrical device is received is greater than a preset threshold, the first conductive piece each is electrically connected to the one electrode of the corresponding power semiconductor through a corresponding elastic structure.

In an embodiment, in the case where the external pressure to the electrical device is less than or equal to a preset threshold, the first conductive piece is substantially not in contact with the circuit board.

In an embodiment, the elastic structure comprises: a metal base with a recess structure; a main spring one end of which is disposed in a recess of the metal base, and the other end of which is disposed in a recess of a corresponding first conductive piece and coupled to the first conductive piece, a conductive auxiliary elastic piece provided independently of the main spring, one end of the auxiliary elastic piece being coupled to the metal base, wherein the other end of the auxiliary elastic piece is not substantially contact with the first conductive piece when the external pressure is less than or equal to the preset threshold, and when the external pressure is greater than the preset threshold, and the other end of the auxiliary elastic piece is in contact with the corresponding first conductive piece, and the auxiliary elastic piece generates an elastic force in a direction opposite to a direction in which a force is applied to the other end of the auxiliary elastic piece.

In an embodiment, the elastic structure is configured such that a side of the metal base thereof opposite to the recess is electrically coupled to the one electrode of the corresponding switching element.

In an embodiment, the first conductive piece is formed of a metal material, the second conductive piece is formed of a metal material, and an external pressure greater than the predetermined threshold is kept applied between the first conductive piece and the second conductive piece.

In an embodiment, when the external pressure is greater than the preset threshold, the first conductive piece is in contact with the circuit board and is electrically connected to a selected conductive component on the circuit board.

In an embodiment, when the external pressure is greater than the preset threshold, each of the first conductive pieces is further electrically connected to at least another electrode of the corresponding switching element through the circuit board.

In an embodiment, the circuit board comprises a top circuit layer, a first insulating and thermally conductive layer, an intermediate circuit layer, a second insulating and thermally conductive layer, and a substrate, wherein the second insulating and thermally conductive layer is disposed between the substrate and the intermediate circuit layer, the intermediate circuit layer is disposed between the first insulating and thermally conductive layer and the second insulating and thermally conductive layer, and the first insulating and thermally conductive layer is disposed between the top circuit layer and the intermediate circuit layer, the switching element has a metal case to which the one electrode of the switching element is electrically connected, the metal case is configured such that an edge thereof is electrically coupled to the top circuit layer of the circuit board, the control electrode of the switching element is electrically coupled to the intermediate circuit layer of the circuit board through a via, and the another electrode of the switching element is electrically coupled to the second conductive piece through a conductive member, wherein the substrate is attached to the second conductive piece.

In an embodiment, the at least one switching element comprises a plurality of switching elements, the plurality of switching elements are divided into a plurality of groups, said one electrodes of the switching elements in each group are electrically connected together, wherein the at least one first conductive piece comprises a plurality of first conductive pieces each of which corresponds to a group, and each switching element in the corresponding group is provided in a corresponding recess of the corresponding first conductive piece, the electrical device further comprises a first insulating isolation structure disposed between the conductive pieces corresponding to two adjacent groups.

In an embodiment, the switching elements in at least one of the groups are arranged in a form of ring or a part of ring, and the switching elements of at least another group are arranged as being a central part surrounded by the ring, wherein the at least one first conductive piece further comprises a first conductive piece corresponding to the central part, and each switching element in the central part is disposed in a corresponding recess in the first conductive piece.

In an embodiment, the electrical device further comprises: a second insulating isolation structure disposed between second conductive pieces corresponding to two adjacent groups.

According to the electrical devices (or, the press-assembly structures) of the embodiments of this aspect of the present disclosure, one or more of the following effects can be achieved:
(1) It is suitable for the array of parallel press-pack type MOSFETs, and has simple and compact structure.
(2) The elastic structure provides pressure to the contact surface, reducing the contact resistance, and with the auxiliary elastic pieces, the current-conducting area can be increased, thereby increasing the current-conducting capacity of the whole press-assembly structure.
(3) The elastic structure provides pressure to the contact surface, reducing the thermal resistance of the contact surface. At the same time, with the copper-based circuit board and the auxiliary elastic piece, the heat dissipation capacity of the whole press-assembly structure can be enhanced.
(4) The elastic structure can limit the upper limit of the pressure on the surface of the MOSFET, so that the range of the pressure applied between the first copper piece and the second copper piece can be larger and the press-assembly structure can be widely applied to various applications.

As below, another aspect of the present disclosure is described.

In an embodiment, an electrical device or electrical component is provided. The electrical device includes: at least one first conductive piece; at least one switching element, each switching element including a control electrode and current electrodes, wherein one of the current electrodes is disposed on a first surface of the switching element and is coupled to the corresponding first conductive piece, the other electrode of the current electrodes and the control electrode are disposed on a second surface of the switching element opposite to the first surface; at least one control electrode connecting member, each including at least one conductive base and at least one elastic conductive structure received in the conductive base, wherein one end of each of the elastic conductive structures is coupled to a corresponding conductive base, and the other end of the elastic conductive structure is adapted to be coupled to a control electrode of a corresponding switching element to provide an electrical connection to the control electrode; at least one second conductive piece, each including one or more raised portions, each raised portion being coupled to the other electrode of the current electrodes of a corresponding switching element.

The control electrode is different from the current electrode. The control electrode may be an electrode for controlling the switching element to be turned on/off . The current electrode may be an electrode that provides a current path when the switching element is turned on. For example, for a MOSFET, the control electrode may be a gate electrode, and the current electrode may be a source electrode or a drain electrode. It should be understood that the present disclosure is not limited thereto.

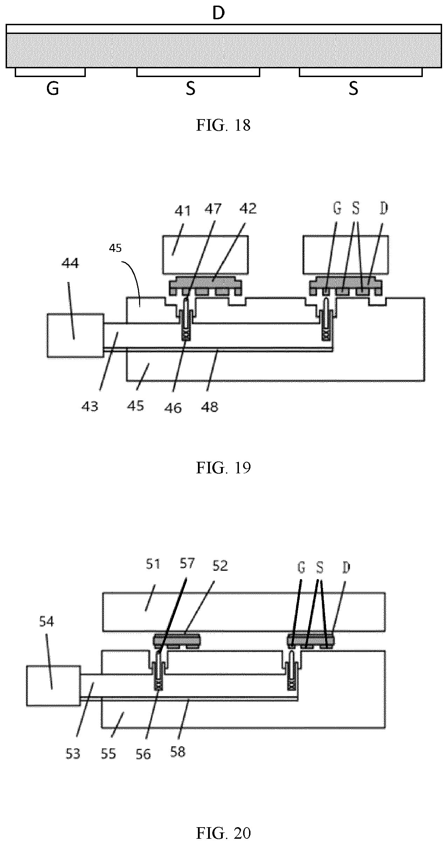

In the specific embodiment shown in FIG. 19, it can be implemented as a press-assembly structure for a press-pack MOSFET having a gate structure. The press-assembly structure includes a first conductive piece (for example, a copper piece) 41, a switching element (for example, a press-pack MOSFET) 42, a gate electrode connecting member 43, a second conductive piece (copper piece) 45, and an elastic conductive structure. The elastic conductive structure may include an elastic structure 46 and a rod-like metal 47 in contact with the gate of the press-pack MOSFET 42. The press-assembly structure may further include an insulating medium 48 between the gate electrode connecting member 43 and the second copper piece 45. The press-assembly structure may further include a connection interface 44 for receiving an external gate control signal.

The gate electrode connecting member 43 may be arranged corresponding to the gate. For example, if the gate is configured in a ring form, the gate electrode connecting member may also be provided in a ring form. Alternatively, if the gate is configured in a grid form, the gate electrode connecting member may also be provided in a grid form.

The first copper piece 41 may be configured to be equipotential with, that is, electrically connected to, an current electrode (for example, a drain electrode) of the press-pack MOSFET 42. The second copper piece 45 may be configured to be equipotential with, that is, electrically connected to, another current electrode (for example, a source electrode) of the press-pack MOSFET 42.

A certain pressure can be maintained between the first copper piece 41 and the second copper piece 45 to reduce the contact resistance and thermal resistance of the contact surface between the first copper piece 41 and the press-pack MOSFET 42.

The source electrode of the press-pack MOSFET 42 is connected to a protrusion portion of the second copper piece 45 and can be connected by press-bonding or welding.

The gate electrode connecting member 43 is placed in a recess of the second copper piece 45 and is electrically insulated from the second copper piece 45.

The gate electrode connecting member 43 is connected to the gate electrode of the press-pack MOSFET 42 through an elastic conductive structure. The elastic conductive structure includes an elastic structure and a conductive member elastically supported by the elastic structure, so that the conductive member is in contact with the corresponding gate electrode. In the embodiment shown in the figure, the elastic conductive structure may include an elastic structure 46 and a rod-like metal 47. The elastic structure 46 can ensure a reliable contact between the rod-like metal 47 and the gate electrode of the press-pack MOSFET 42, and can also prevent the contact stress from being too large or too small due to the dimensional matching problem.

The gate electrode connecting member 43 may be connected to the connection interface 44 to receive an external gate control signal. The connection interface 44 is, for example, a coaxial cable interface to connect to the outside through a coaxial cable.

The gate electrode connecting member 43 may be a metal structure. Since it is placed in the recess of the second copper piece 45, the insulation medium 48 is used to electrically isolate one of these two from another. For the gate electrode connecting member 43, a circuit board may also be employed. In such a case, when appropriate, the surface of the circuit board may be provided with an electrical isolation layer to avoid undesirable electrical connections with other components.

For the gate electrode connecting member 43 of a metal structure, the upper surface may have a recess, and the elastic conductive structure may be disposed in the recess. For the gate electrode connecting member 43 of the circuit board, a cylindrical structure member may be used to be disposed in a preset positioning hole of the circuit board, and then an elastic conductive structure is disposed in the cylindrical structure member.

Here, the switching element may be a packaged switching element, for example, it may comprise, but is not limited to, DirectFET™.

Here, it should also be noted that, in the embodiment shown in FIG. 19, since the switching element 42 is a packaged structure, and one current terminal (for example, drain terminal) thereof is connected to the upper package case, a gap (e.g., a recess) is provided at a position of the second conductive piece corresponding to the edge of the upper package case to provide electrical isolation, for example, to electrically isolate the case from the second conductive piece or other components.

In another embodiment, an electrical device is shown in FIG. 20. The structure of the electrical device is basically similar to that shown in FIG. 19, except that the switching element is in a form of die, that is, it is not packaged. Here, the term "die" is used to indicate that it can be a whole wafer or a part of a wafer. As shown in FIG. 20, the first copper piece may be the same as that of FIG. 4, to use a separate copper piece. According to this embodiment, for the die of a switching element such as a press-pack MOSFET, it is not affected by the package structure, and the pressure is not limited to 50-100N. Therefore, as shown in FIG. 5, an integral first copper piece 51 can be used and a relatively large pressure, such as dozens of kN can be applied. In this way, the scope of applications to which it can be applied can be extended and the costs can be reduced.

Since the drain electrode D of the press-pack MOSFET die 52 is located above the press-pack MOSFET die 52 and the source and gate electrodes are located below, the second copper piece 55 only needs to be provided with recess according to the setting of the gate electrode connecting member 53, without need to consider the electrical insulation from the drain electrode. The connection structure between the gate electrode connecting member 53 and the gate electrode of the press-pack MOSFET die 52 is similar to that of FIG. 19. The gate electrode connecting member 53 and the gate electrode of the press-pack MOSFET die 52 are connected through an elastic structure 56 and a rod-like metal 57.

In the embodiment of FIG. 20, the gate electrode connecting member 53 may be provided in a ring form or a grid form, occupying only a small space of the second copper piece 55, thereby saving space. In addition, with the elastic structure good electrical contact can be ensured. In addition, since the first copper piece 51 is directly connected to the drain electrode of the press-pack MOSFET die 52, the second copper piece 55 is directly connected to the source electrode of the press-pack MOSFET die 52, and there is a certain pressure between the first copper piece 51 and the second copper pieces 55, the paths for the heat generated by the power device (for example, MOSFET) to dissipate to the upper and lower surfaces can be shortened, and the thermal resistance on the paths can be reduced.

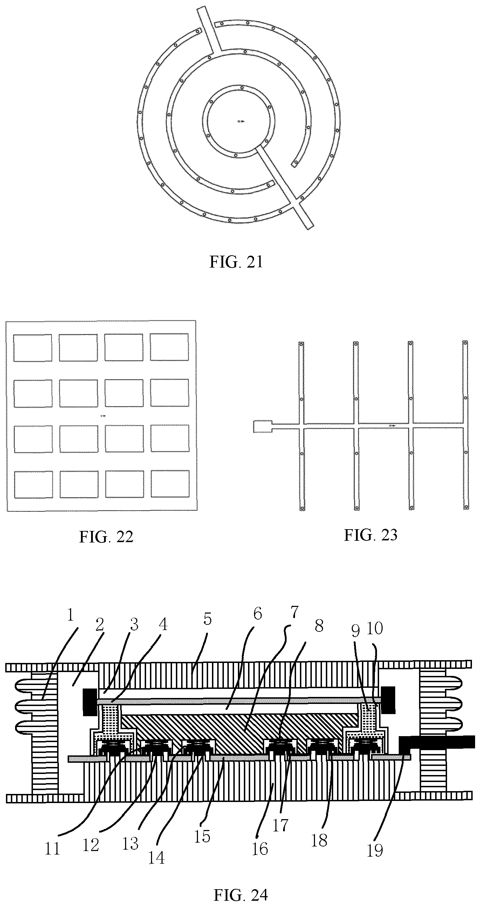

In an embodiment, the shape of the gate electrode connecting member can be designed according to the arrangement of the array of press-pack MOSFETs. As shown in FIG. 16, a press-pack MOSFET array in ring form is illustrated. A design scheme of a gate electrode connecting member is shown in FIG. 21. If the press-pack MSOFETs in the inner ring and the outer ring are controlled using a same gate electrode signal, an inner ring and an outer ring of the corresponding gate electrode connecting member can be electrically connected. If different gate electrode signals are used for control, for example, an intermediate ring is employed, then different gate electrode connecting members are used for connection. For press-pack MOSFET array in matrix form, as shown in FIG. 22, if a same gate electrode signal is used for control it, a design scheme of the gate electrode connecting member is shown in FIG. 23. In the example of FIG. 23, all the press-pack type MSOFETs in the array are controlled using a same gate electrode signal. If different gate electrode signals are used for control, the aforementioned gate electrode connecting members for the ring(s) of the press-pack MOSFET array may be used.

It should also be understood that according to this aspect of the present disclosure, the following examples can also be provided.

There is provided an electrical device comprising: at least one first conductive piece; at least one switching element each comprising a control electrode and current electrodes, wherein one of the current electrodes is disposed on a first surface of the switching element and is coupled to a corresponding first conductive piece, the other electrode of the current electrodes and the control electrode are disposed on a second surface of the switching element opposite to the first surface; at least one control electrode connecting member each comprising at least one conductive base and at least one elastic conductive structure received in the conductive base, wherein one end of each of the elastic conductive structures is coupled to a corresponding conductive base, and the other end of the elastic conductive structure is adapted to be coupled to a control electrode of a corresponding switching element to provide an electrical connection to the control electrode; at least one second conductive piece each comprising one or more raised portions, each of the raised portion being coupled to the other electrode of the current electrodes of a corresponding switching element.

In an embodiment, the control electrode connecting member is placed in a recess of the second conductive piece, the electrical device further comprises an insulating medium for electrically insulating the control electrode connecting member from the second conductive piece.

In an embodiment, a certain pressure is maintained between the first conductive piece and the second conductive piece.

In an embodiment, the at least one switching element comprises a plurality of switching elements, and the plurality of switching elements are divided into a plurality of groups.

In an embodiment, the switching elements in each group are arranged in one of the following form: ring(s), part of ring(s), or a matrix.

In an embodiment, the at least one control electrode connecting member is configured as one of the following: the at least one control electrode connecting member comprises only one control electrode connecting member to use the one control electrode connecting member to electrically connect all the switching elements; or the at least one control electrode connecting member comprises a plurality of control electrode connecting members that are independent of each other, and each control electrode connecting member is electrically connected to a switching element in a corresponding group.

In an embodiment, the elastic conductive structure comprises an elastic structure and a metal connecting member, and the metal connecting member is elastically supported by the elastic structure to ensure that the metal connecting member and the control electrode of the switching element are reliably connected.

In an embodiment, the switching element is one of: a packaged switching element; and a switch element die.

In an embodiment, the one electrodes of the switching elements in each group are electrically connected together, the at least one first conductive piece comprises a plurality of first conductive pieces, and each of the first conductive pieces corresponds to a group, and the one electrode of each switching element in the corresponding group is coupled to the first conductive piece, the electrical device further comprises a first insulating isolation structure disposed between the conductive pieces corresponding to two adjacent groups.

In an embodiment, the switching elements in at least one of the groups are arranged in a form of ring or of a part of ring, the switching elements of at least another group are arranged as a central part surrounded by the ring, and the one electrode of each switching element in the central part is electrically connected together, wherein the at least one first conductive piece further comprises a first conductive piece corresponding to the central part, and the one electrode of each switching element in the central portion is coupled to the first conductive piece.

In an embodiment, the at least one second conductive piece comprises a plurality of second conductive pieces, each second conductive piece corresponds to a group, and another electrode of each switching element in the corresponding group is coupled to the second conductive piece, the electrical device further comprises a second insulating isolation structure disposed between the second conductive pieces corresponding to two adjacent groups.

In an embodiment, the at least one second conductive piece further comprises a second conductive piece corresponding to the central part, wherein the another electrode of each switching element in the central portion is coupled to the second conductive piece.

According to the electrical devices (e.g., press-assembly structures) of the present disclosure, one or more of the following effects can be achieved:
(1) Being suitable for array of parallel press-pack switching elements, with simple and compact structure.
(2) The pressure is provided to the contact surface through the elastic structure, reducing the contact resistance, and with the auxiliary elastic pieces, the current-conducting area can be increased, thereby increasing the current-conducting capacity of the overall structure.
(3) The pressure is provided to the contact surface through the elastic structure, reducing the thermal resistance of the contact surface. At the same time, with the copper-based circuit board, the heat dissipation ability of the overall structure can be enhanced.
(4) The elastic structure can limit the upper limit of the pressure on the surface of the switching element, so that the range of pressure applied between the first copper piece and the second copper piece is enlarged and the range applications to which it can be applied is widened.

Compared with the prior art, the press-assembly structure for press-pack switching element array according to the present disclosure also has the following effects:
(1) A gate structure suitable for the array of parallel press-pack switching elements is provided with is simple and compact structure.
(2) A gate electrode connecting member in a ring form or grid form is provided without affecting the connection between the first and second copper pieces and the switching elements. And a certain pressure can be applied between the first copper piece and the second copper piece to reduce the contact surface resistance and thermal resistance.
(3) The gate electrode connecting member is connected to the gate electrode of the switching element through an elastic structure and a rod-like metal, which can ensure a certain pressure at the connection and ensure a reliable connection without being subject to the pressure between the first copper piece and the second copper piece, and the switching elements can be avoided from being damaged due to an excessive pressure.

As below, descriptions will be given in association with a still another aspect of the present disclosure.

With the rapid development of power electronics technology, requirements are requested by the users for power semiconductor devices (herein referred to as semiconductor devices or power devices for short), such as fast commutation speed when turning off, high turn-off reliability, and good heat dissipation performance. The package structure for a power semiconductor device is particularly critical for a good electrical connection between the semiconductor device and an external circuit, especially for power semiconductor devices suitable for use in high-voltage and high-current environments.

Conventionally, in a power semiconductor device, a power semiconductor component (sometimes referred to as device wafer, device chip, or device die) and a turn-off module are placed in a package (also referred to as a case), and a cathode is provided at both the inner side and the outer side of the gate electrode ring of the power semiconductor component, and the conductive piece used to connect the cathode needs to provide an isolated channel for the connection to the gate electrode, that is, multiple cathode conductive pieces are needed, which results in a complicated package structure.

In addition, when GCT or GTO is employed, it needs to press-bond molybdenum sheets on both sides thereof, and apply a pressure of more than tens of kN, while a single press-pack switching element can only withstand a pressure of 50-100N. Therefore, if the switching element is integrated in the case, there may be pressure difference and coordination issues between different components.

In view of this, a technique as described in this aspect of the present disclosure is proposed.

According to an embodiment of the present disclosure, there is provided an electrical device which comprises a power semiconductor device having a control electrode and current electrodes, wherein the control electrode is arranged in a ring form, and the control electrode is disposed outside one of the current electrodes; a driving module for driving the power semiconductor device, the driving module including a plurality of switching elements, the plurality of switching elements being divided into a plurality of groups; a plurality of first conductive members provided at a side of the power semiconductor device for providing connections of corresponding switching elements to the one of the current electrodes and connections of corresponding switching elements to the control electrode, respectively, wherein at least one group of the plurality of groups of switching elements is electrically connected to the control electrode of the power semiconductor device; and one or more conductive elastic structures, wherein one end of each elastic structure is electrically connected to a corresponding first conductive piece, and the other end is electrically connected to a corresponding switching element.

In a specific implementation, as shown in FIG. 24, the electrical device includes a power semiconductor device 4, a first conductive piece 7, a connecting member 9, a conductive elastic structure 8, and a driving module. The driving module may be used to drive the power semiconductor device. The driving module includes a plurality of switching elements. In an embodiment, the electrical device further includes at least one circuit board 15, and the plurality of switching elements are disposed on corresponding circuit boards. One current electrode terminal and the control electrode terminal of each switching element are coupled to corresponding circuit board(s). The electrical device may further include a second conductive piece 16. The electrical device may further include a third conductive piece 5. In some embodiments, optionally, the surface of the power semiconductor device 4 is coupled with a conductive sheet. The conductive sheet 3 and the conductive sheet 6 are shown in the figure. The conductive sheet 3 is connected to the upper surface of the power semiconductor device 4. The conductive sheet 6 is connected to a lower surface of the power semiconductor device 4. The conductive sheets 3 and 6 may be, but are not limited to, metal sheet, such as a molybdenum sheet. The conductive sheet 6 is coupled to the first conductive piece 7. At least one recess is provided at the bottom of the first conductive piece 7, and an elastic structure and a switching element are provided in the recess. The first conductive piece 7 is also used to provide an electrical connection between the power semiconductor device 4 and an current electrode of the switching element. The switching elements may be provided or mounted on the circuit board 15, and may be connected to conductive members on the circuit board 15, respectively. The circuit board 15 is also coupled to the second conductive piece 16.

The connecting members 9 may be disposed at both sides of the first conductive piece 7 and separated from the first conductive piece 7. Therefore, an insulating piece 10 may be provided at the outside of the connecting members 9. One end of the connecting member 9 is connected to the control electrode (gate electrode) of the power semiconductor device, and the other end is connected to the associated switching element through an associated elastic structure 8.

Here, in some embodiments, both the connecting members 9 and the first conductive piece 7 may be regarded as first conductive members. That is, the electrical device includes the first conductive members 7 and 9.

In the embodiment, examples of the power semiconductor device 4 may include (but are not limited to) common thyristors (SCR), gate commutated thyristors (GCT), gate turn-off thyristors (GTO), or the like. The power semiconductor device 4 may be formed in a semiconductor substrate, and therefore, in FIG. 24, reference numeral 4 may also be used to indicate the semiconductor substrate. A control electrode (for example, a gate electrode or a grid electrode) and a current electrode (for example, a cathode, denoted by K) of the power semiconductor device 4 are provided on one surface of the semiconductor substrate. And another current electrode (for example, an anode, denoted by A) of the power semiconductor device 4 may be provided on the other surface of the semiconductor substrate opposite to said one surface.

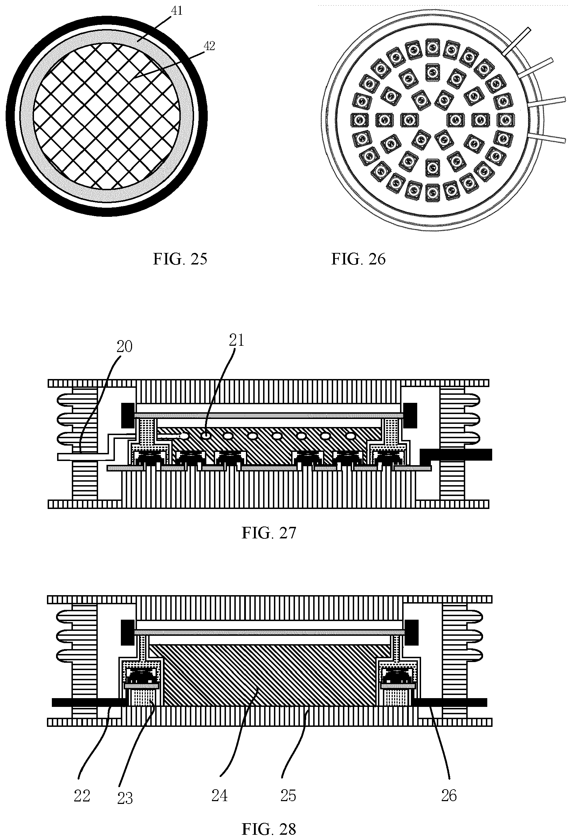

In some embodiments, the power semiconductor device may have a control electrode (gate electrode G) and current electrodes (anode A and cathode K). The control electrode of the power semiconductor device 4 is arranged in a ring form on the semiconductor substrate. As shown in FIG. 25, the control electrode (gate electrode) 41 is arranged in a ring form and is disposed outside the current electrodes 42 (cathode or anode).

In the embodiment, the driving module may be disposed on the circuit board. The driving module may include a turn-off module and/or a turn-on module. The turn-off module includes at least one switching element including a drain terminal and a source terminal as current terminals and a gate terminal as control terminal. The drain terminal and the gate terminal of the switching element may be coupled to the circuit board. In FIG. 24, the circuit board is provided with a switching element Q_{G} and a switching element Q_{E}. The switching element Q_{G} includes a drain terminal 11, a source terminal 12 and a gate terminal 18. The drain terminal 11 and the gate terminal 18 are coupled to the circuit board 15, and the source terminal 12 is coupled to the second conductive piece 16. The switching element Q_{E} includes a drain terminal 13, a source terminal 14 and a gate terminal 17. The drain terminal 13 and the gate terminal 17 are coupled to the circuit board 15, and the source terminal 14 is coupled to the second conductive piece 16. Preferably, in order to ensure that the second conductive piece 16 is tightly connected to the source terminal of the switching element, a protrusion is provided on the second conductive piece 16. In some embodiments, the height of the protrusion is consistent with the thickness of the circuit board 15.

In some embodiments, the switching element may comprise a DirectFET or a press-pack MOSFET. The DirectFET is a type of metal-oxide-semiconductor field-effect transistor (MOSFET) produced by and commercially available from the International Rectifier Company, which has a metal case connected to a current electrode (typically a drain electrode) of the MOSFET, and the case can be directly coupled to an external device (such as a PCB, etc.). In some implementations, the electrical device may include a plurality of switching elements arranged in an array. For example, the array of press-pack MOSFETs may be arranged in an annular arrangement or a matrix arrangement.

As shown in FIG. 26, a schematic arrangement of switching elements according to an embodiment of the present disclosure is shown. The plurality of switching elements may be divided into a plurality of groups. The plurality of switching elements in a group are arranged in a ring form or a part of a ring form. In FIG. 26, a plurality of switching elements are arranged in an approximately concentric rings, and each ring in FIG. 26 comprises one or more switching elements. In an embodiment, the outer ring in FIG. 26 may correspond to the switch Q_{G} in the turn-off module in the drive module shown in FIG. 1, and the middle ring and the inner ring may correspond to the switch Q_{E} in the turn-off module in the drive module shown in FIG. 1. Although FIG. 26 here illustrates that the switching elements are arranged on the circuit board in a circular ring form and 3 concentric rings are provided, it should be understood that the switching elements can also be arranged on the circuit board in a ring form of any other shape, for example, ellipse, square, polygon, etc.; and that the switching elements may be provided in one or more circular rings, for example, a single ring as shown in FIG. 15.

As shown in FIG. 13, according to an embodiment of the present disclosure, an elastic structure suitable for a press-pack MOSFET is also introduced. The elastic structure includes a main spring 6, conductive auxiliary elastic pieces 7, and a metal base 8. The main spring 6 is preferably conductive. The metal base 8 has a recess structure. One end of the main spring 6 is coupled to the recess of the metal base 8. One end of each of the auxiliary elastic pieces 7 is coupled to the metal base 8. The other end of the main spring 6 is coupled to a recess (for example, a bottom wall of the recess) at the bottom of the first conductive piece 7 so as to be coupled to the first conductive piece 7. In some embodiments, when the external pressure is less than or equal to a predetermined threshold (for example, no external pressure), the other ends of the two auxiliary elastic pieces 7 are in slight contact with or not contact with the bottom recess of the first conductive piece 7. When the external pressure is greater than the preset threshold, the other ends of the auxiliary elastic pieces are in contact with the corresponding first conductive piece. In such a case, the auxiliary elastic pieces can generate an elastic force opposite to the direction in which the other ends receive force, thereby ensuring good and reliable electrical contact.

According to some embodiments of the present disclosure, the circuit board 15 may be a circuit board as previously described with respect to FIG. 14. For example, the circuit board 15 includes a top circuit layer, a first insulating and thermally conductive layer, an intermediate circuit layer, a second insulating and thermally conductive layer, and a copper substrate. For the circuit board 15, n ordinary FR4 substrate circuit board, or an aluminum-based substrate or a copper-based substrate can be employed.

The elastic structure 8 may be the elastic structure as described in conjunction with FIG. 12, and repeated description thereof is thus omitted here.

According to the embodiments of the present disclosure, when the pressure applied between the first conductive piece 7 and the second conductive piece 16 is small (for example, less than or equal to a threshold value), the elastic structure 8 is deformed less, and the first conductive piece 7 and the circuit board 15 are not in contact. The first conductive piece 7 is electrically connected to the drain terminal of the press-pack MOSFET only through the elastic structure 8. The auxiliary elastic piece 7 in the elastic structure 8 is used to increase the current-conducting area and contact area, and reduce the electric resistance and thermal resistance.

When the pressure applied between the first conductive piece 7 and the second conductive piece 16 is large so that the elastic structure 8 is substantially deformed (for example, greater than a predetermined threshold), and the first conductive piece 7 is in contact with the circuit board 15. The first conductive piece 7 can be electrically connected to the drain electrode of the press-pack MOSFET not only through the elastic structure 8, and but also through the contact surface between the first conductive piece 7 and the circuit board 15 and the copper-clad area of the top circuit layer of the circuit board 15. As a result, the area of current-conducting between the first conductive piece 7 and the drain electrode of the press-pack MOSFET is increased, and the current resistance is reduced. The auxiliary elastic pieces 7 in the elastic structure 8 are used to increase the flow area and contact area, and reduce the flow resistance and thermal resistance.

In the embodiment, the elastic structure 8 may also be a spring, such as a butterfly spring. With such a spring structure, it can be ensured that the switching element is tightly coupled to the cathode of the power semiconductor device through the cathode copper piece without being crushed by excessive pressure.

In the embodiment, as shown in FIG. 24, the electrical device further includes a coaxial cable 19, and the circuit board is connected to the driving circuit through the coaxial cable 19. Preferably, multiple coaxial cables 19 may be provided, for example, to provide gate electrode signal(s) for switching element(s), or to provide a gate-to-cathode connection or gate-to-negative electrode connection for injecting a turn-on gate current, or to provide a cathode-to-negative electrode connection for overcurrent protection detection.

In the embodiment, the electrical device may further include a package case, which may, together with the second conductive piece 16 and the third conductive piece 5, encapsulate the power semiconductor device 4 and the driving module. Specifically, the package case may include a support member 1. Each of the third conductive piece 5 and the second conductive piece 16 may have an extension portion extending from a side thereof. The support member 1 may be disposed between the extension portions of the third conductive piece 5 and the second conductive piece 16 to form a cavity 2. The power semiconductor device 4, the circuit board 15 and the like may be disposed in the cavity 2. The support member 1 may be formed of ceramic. In an embodiment, protrusions (also referred to as umbrella skirt structure) may be provided on the outer side of the support member 1 as shown in FIG. 24 in order to increase the creepage distance and improve the insulation performance. In an embodiment, the sealed cavity 2 may be filled with a gas that is stable in nature and not easily decomposed, such as nitrogen, helium, etc., thereby further protecting the power semiconductor device 4 from being affected by the external environment. The support member 1 may also be provided with an opening for passing the coaxial cable 19 therethrough.

As shown in FIG. 27, a schematic diagram showing a structure of another electrical device according to an embodiment of the present disclosure is illustrated. The structure shown in FIG. 27 is basically the same as the structure of FIG. 24, except that the electrical device in FIG. 27 is added with water cooling channels 20 on basis of the structure of FIG. 24, and a plurality of channels are provided in the first conductive pieces 7. Therefore, with the water-cooling channel provided in the electrical device, it can be ensured that the power semiconductor device can be effectively cooled.

FIG. 28 shows a schematic diagram illustrating a structure of another electrical device according to an embodiment. Similar to FIG. 24, the electrical device may include a power semiconductor device, a circuit board, a driving module including one or more switching elements arranged on the circuit board, a first conductive piece 24, a second conductive piece 25, one or more elastic structures, and one or more connecting members. The embodiment shown in FIG. 28 is different from the embodiment shown in FIG. 24 in that the circuit board is disposed on a side of the first conductive piece 24; the gate terminals, the source terminals, and the drain terminals of the switching elements can be electrically connected to the circuit board through welding/soldering or other available electrical connection means; and the driving module arranged on the circuit board may further include a capacitor 23 attached to the circuit board (on the lower surface of the circuit board in the figure). In an embodiment, the capacitor 23 may be electrically connected to the switching element through the circuit board. A coaxial cable 22 for pre-charging the capacitor 23 and A control cable 26 for the gate terminal of the switching element are also illustrated in FIG. 28.

In the embodiments, the first conductive piece illustrated in FIG. 24, FIG. 27, or FIG. 28 may be integrally formed. Preferably, if press-pack MOSFET(s) is adopted for the switching element(s) and the elastic structure(s) shown in FIG. 13 is used, and further, if for the press-pack MOSFET(s) the arrangement as shown in FIG. 16 is employed in which the drain electrodes of the MOSFETs in different rings have different potentials, then multiple first conductive pieces may need to be provided and insulating ring barrier may need to be provided between different first conductive pieces, as shown in FIG. 17. In addition, if the source electrodes of the MOSFETs in different rings have different potentials, multiple second conductive pieces accordingly need to be provided.

In the embodiment, the first conductive piece, the second conductive piece, and the third conductive piece are all metal pieces with conductive property, such as copper pieces.

FIG. 11b shows a circuit diagram of an electrical device according to an embodiment of the present disclosure. The electrical device may include a driving module, a case, and a power semiconductor device. The driving module can be used to drive the power semiconductor device to perform a switching operation. The drive module includes at least a turn-off module for turning off the power semiconductor device. In FIG. 11b, the turn-off module of the electrical device includes at least switching elements Q_{G} and Q_{E}. When turning off the power semiconductor device, the switch Q_{G} of the module is turned on, and the switch Q_{E} is turned off, and the current is commutated from the cathode K of the power semiconductor device to the gate electrode G, so that the power semiconductor device is turned off.

FIG. 11a is a schematic circuit diagram of another electrical device according to an embodiment of the present disclosure. The electrical device shown in FIG. 11a includes a turn-off module, a case, and a power semiconductor device. The turn-off module shown in FIG. 11a may include a switching element Q_{G}, a capacitor COFF, and a voltage source V. The voltage source V can be used to pre-charge the capacitor COFF. When turning off the power semiconductor device, the switch Q_{G} is turned on, so that the current is commutated from the cathode K to the gate electrode G through the pre-charged capacitor COFF, thus the power semiconductor device is turned off.

In the embodiment, the power semiconductor device may have a control terminal (G) and current terminals (A and K). Examples of power semiconductor device may include, but is not limited to, gate communicated thyristors (GCT), gate turn-off thyristors (GTO), or the like. The electrical device shown in FIG. 29 may constitute an integrated gate communicated thyristor (IGCT). The electrical device shown in FIG. 24 may constitute an emitter turn-off thyristor (IETO) and an internal commutated thyristor (ICT).

In the embodiment, the electrical device is a combination of a thyristor-based device and a corresponding package structure, and can be used for controlling an electronic circuit or the like.

It should also be understood that the following embodiments are also contemplated according to this aspect of the present disclosure.

There is provided an electrical device comprising: a power semiconductor device having a control electrode and current electrodes, the control electrodes being arranged in a ring form and disposed outside one of the current electrodes; a driving module for driving the power semiconductor device, the driving module comprising a plurality of switching elements which are divided into a plurality of groups; a plurality of first conductive members disposed on a side of the power semiconductor device, and used to respectively provide a connection of a corresponding switching element to the one of the current electrodes and a connection of a corresponding switching element to the control electrode, wherein at least one group of the plurality of groups of switching elements is electrically connected to the control electrode of the power semiconductor device; one or more conductive elastic structures, one end of each elastic structure being electrically connected to a corresponding first conductive piece, and the other end being electrically connected to a corresponding switching element.

In an embodiment, each of the elastic structures is one of the following: a conductive spring; an elastic structure comprising a conductive base, a conductive auxiliary elastic piece, and a spring, wherein the base is coupled to a current terminal of a corresponding switching element, and a recess is provided on a side of the base opposite to the corresponding switch, an end of the spring is disposed in the recess of the base and is coupled to the base, the other end of the spring is coupled to a corresponding first conductive member, the auxiliary elastic piece is provided independently of the spring, and an end of the auxiliary elastic piece is coupled to the base.

In an embodiment, the other end of the auxiliary elastic piece does not substantially contact the first conductive piece when an external pressure is less than or equal to a preset threshold, and when the external pressure is greater than the preset threshold, the other end of the auxiliary elastic piece is in contact with the corresponding first conductive piece, and the auxiliary elastic piece generates elastic force in a direction opposite to a direction of the force which the other end receives.

In an embodiment, other groups than the at least one of the plurality of groups of switching elements are arranged in one of the following forms: a ring, a portion of a ring , or a matrix.

In an embodiment, the plurality of first conductive members comprise a first conductive member corresponding to the control electrode of the power semiconductor device, the electrical structure further comprises an insulating isolation structure provided between the first conductive member corresponding to the control electrode of the power semiconductor device and other first conductive member(s).

In an embodiment, the other groups are arranged in a ring form or a matrix form, the plurality of first conductive members comprise a first conductive member corresponding to the control electrode of the power semiconductor device, the electrical structure further comprises an insulating isolation structure disposed between the first conductive members corresponding to two adjacent rings or to adjacent ring and the matrix.

In an embodiment, the electrical device further comprises: at least one circuit board, wherein the plurality of switching elements are disposed on a corresponding circuit board, and the one current electrode terminal and the control electrode terminal of each of the switching elements are coupled to the corresponding circuit board.

In an embodiment, the electrical device further comprises: at least one second conductive member coupled to the circuit board; wherein when a pressure applied between the plurality of first conductive members and the at least one second conductive member is less than or equal to a preset pressure value, the first conductive members are not in contact with the corresponding circuit board, and the first conductive members can be connected to said one current electrode terminals of the corresponding switching elements through corresponding elastic structures; when the pressure applied between the plurality of first conductive members and the at least one second conductive member is greater than the preset pressure value, the first conductive members are in contact with the corresponding circuit boards, and the first conductive members can be connected to the one current electrode terminals of the corresponding switching elements through the corresponding elastic structures, and also can be connected to the one current electrode terminals of the switching elements through the corresponding circuit boards, and the one current electrode terminals are disposed on a side of the switching elements opposite to the control electrodes.

In an embodiment, the plurality of first conductive members comprise a conductive piece and one or more connecting members, the connecting members being disposed on a side of the conductive piece and is isolated from the conductive piece, the connecting members are connected to a part of the control electrode, and the connecting members are associated with corresponding switching elements through the elastic structures.

In an embodiment, the electrical device further comprises: a third conductive member coupled to a current electrode of the power semiconductor device disposed on the other surface of the semiconductor substrate; and a package case, together with the second conductive member and the third conductive member, enclosing the power semiconductor device and the driving module.

Compared with the prior art, have one or more of the following effects can be achieved according to the embodiments of the present disclosure.
1. For the electrical devices, the turn-off circuit is integrated inside the case, which significantly reduces the area of the commutation loop, reduces the stray inductance of the commutation loop, and improves the commutation speed.
2. With the elastic structure of the electrical device, it can be ensured that the switching element(s) is tightly coupled to the cathode of the power semiconductor device through the conductive piece, and that the upper limit of the value of the pressure applied on the surface of the switching element can be limited, so that the switching element(s) will not be damaged by excessive pressure. Therefore, the pressure range applied between the first conductive piece and the second conductive piece can be enlarged, and the electric device can be widely applied to various applications.
3. The elastic structure also serves to provide pressure for the contact surface between the conductive piece and the circuit board, reducing the contact resistance. And with the auxiliary elastic piece, the current-conducting area can be increased, thereby increasing the current-conducting capacity of the overall structure. Meanwhile, the circuit board can utilize a copper-based circuit board. And the elastic structure has auxiliary elastic pieces, enhancing the heat dissipation ability of the overall structure.
4. The electrical device may have a water-cooling channel, which can ensure the effective heat dissipation of the power semiconductor devices.
5. The electrical device can be applied to a thyristor device with a gate electrode ring at an outer side, thus only one cathode conductive piece is required in such an electrical device, simplifying the structure and reducing production costs.
6. The switching elements are arranged in a parallel array, and the structure is simple and compact.

As so far, it should be understood that the present disclosure also provides an electrical device that may include any electrical device as described in detail above. The driving module may include a turn-off module, a turn-on module, and/or the like.

Various embodiments of the present disclosure have been described above, but it is to be noted that the above description is merely exemplary and not for enumerating, and the present disclosure shall not be limited to the various embodiments as disclosed herein. The embodiments disclosed herein may be arbitrarily combined without departing from the spirit and scope of the present disclosure. In light of the present disclosure, any modifications and changes which are obvious for those of ordinary skills in the related art are also encompassed within the spirit and scope of the disclosure.

## Claims

1. An electrical device comprising:
a semiconductor substrate having a power semiconductor device thereon, wherein a control electrode and a first current electrode of the power semiconductor device are arranged on a surface of the semiconductor substrate;
a printed circuit board on which a driving module for driving the power semiconductor device is arranged, the driving module comprising at least one first switching element each comprising a control terminal and current terminals;
a first conductive piece disposed between the semiconductor substrate and the printed circuit board and used to provide an electrical connection to the first current electrode;
one or more connecting members each of which passes through, and is electrically isolated from, the first conductive piece, and is connected to a part of the control electrode, and each being associated with a corresponding first switch element; and
one or more first spring members, each of which is interposed between a corresponding connecting member and a first switching element associated with the corresponding connecting member, so that a first current terminal of the current terminals of each first switching element is electrically connected to a part of the control electrode through the connecting member.

2. The electrical device according to claim 1, wherein the control electrode is arranged in a ring form on the semiconductor substrate.

3. The electrical device according to claim 1, wherein the at least one first switching element comprises a plurality of the first switching elements, and the plurality of first switching elements are divided into a plurality of groups, wherein at least one group corresponds the control electrode of the power semiconductor device.

4. The electrical device according to claim 1, wherein each of the first switching elements comprises a drain terminal and a source terminal as the current terminals and a gate terminal as the control terminal, and a second current terminal and the gate terminal of the first switching element are coupled to the printed circuit board, wherein a first current terminal thereof is one of the drain terminal and the source terminal, and the second current terminal is the other of the drain terminal and the source terminal.

5. The electrical device according to claim 1, wherein the first spring member is one of:
a conductive spring; and
a conductive elastic structure comprising a spring and a conductive member.

6. The electrical device according to claim 1, wherein the first conductive piece comprises a first opening therethrough, and the first opening is adapted to receive therein a corresponding connecting member, a corresponding first switching element, and a corresponding first spring member.

7. The electrical device according to claim 1, wherein the connecting member has a protruding first portion and a recessed second portion, a lateral dimension of the first portion being less than that of the second portion, wherein a corresponding first switching element and a corresponding first spring member are received in the second portion, and the recess comprises a side arm disposed at an edge of the recess and extending to the printed circuit board.

8. The electrical device according to claim 1, further comprising an insulating member arranged between the connecting member and the first conductive piece to insulate them from each other.

9. The electrical device according to claim 3, wherein the first switching elements in each of the groups are arranged in one of the following forms:
ring(s), part of ring(s), or a matrix.

10. The electrical device according to claim 1, further comprising:
one or more second switching elements placed on the same surface of the printed circuit board as the first switching element, and
one or more second spring members each of which is disposed between a corresponding second switching element and the first conductive piece, so that the second switching elements are electrically connected to the first current electrode of the power semiconductor device through the first conductive piece,
wherein the second switching elements and the second spring members are disposed in recesses of the conductive piece.

11. The electrical device according to claim 10, wherein the plurality of second switching elements are distributed in a ring arrangement on the printed circuit board, and a second switching element is arranged on each of both sides of at least a portion of the first switching elements symmetrically in a radial direction of the ring.

12. The electrical device according to claim 1, wherein a channel for cooling is provided in the first conductive piece.

13. The electrical device according to claim 1, wherein
the first switching elements comprise DirectFETs, and
the power semiconductor device comprises a Gate Commutated Thyristor (GCT) or a Gate Turn-off Thyristor (GTO).

14. The electrical device according to claim 1, further comprising:
a second conductive piece coupled to the other side of the printed circuit board;
a third conductive piece coupled to a second current electrode of the power semiconductor device which is disposed on the other surface of the semiconductor substrate; and
a package case which, together with the second conductive piece and the third conductive piece, encapsulates the power semiconductor device and the driving module.

15. An electrical device comprising:
at least one first conductive piece each provided with at least one recess;
at least one elastic structure each placed in a corresponding recess, an end of the elastic structure electrically connected to the first conductive piece;
at least one switching element each of which is disposed in a corresponding recess, one electrode of the switching element coupled to the other end of the corresponding elastic structure disposed in the corresponding recess;
a circuit board on a side of which the switching element is disposed, wherein at least one of other two electrodes of each of the switching elements is electrically connected to the circuit board; and
at least one second conductive piece, the other side of the circuit board being attached to the at least one second conductive piece,
wherein in the case that an external pressure that the electrical device is received is greater than a preset threshold, the first conductive piece each is electrically connected to the one electrode of the corresponding switching element through the corresponding elastic structure.

16. The electrical device according to claim 15, wherein, in the case where the external pressure to the electrical device is less than or equal to the preset threshold, the first conductive piece is substantially not in contact with the circuit board.

17. The electrical device of claim 15, wherein the elastic structure comprises:
a metal base with a recess structure;
a main spring one end of which is disposed in the recess of the metal base, and the other end of which is disposed in a recess of a corresponding first conductive piece and coupled to the first conductive piece,
a conductive auxiliary elastic piece provided independently of the main spring, one end of the auxiliary elastic piece being coupled to the metal base, wherein the other end of the auxiliary elastic piece is not substantially contact with the first conductive piece when the external pressure is less than or equal to the preset threshold, and when the external pressure is greater than the preset threshold, the other end of the auxiliary elastic piece is in contact with the corresponding first conductive piece, and the auxiliary elastic piece generates an elastic force in a direction opposite to a direction in which a force is applied to the other end of the auxiliary elastic piece.

18. The electrical device according to claim 17, wherein the elastic structure is configured such that a side of the metal base thereof opposite to the recess is electrically coupled to the one electrode of the corresponding switching element.

19. The electrical device according to claim 15, wherein
the first conductive piece is formed of a metal material,
the second conductive piece is formed of a metal material, and
an external pressure greater than the predetermined threshold is kept applied between the first conductive piece and the second conductive piece.

20. The electrical device according to claim 15, wherein:
when the external pressure is greater than the preset threshold, the first conductive piece is in contact with the circuit board and is electrically connected to a selected conductive component on the circuit board.

21. The electrical device according to claim 15, wherein when the external pressure is greater than the preset threshold, each of the first conductive pieces is further electrically connected to at least another electrode of the corresponding switching element through the circuit board.

22. The electrical device according to claim 15, wherein:
the circuit board comprises a top circuit layer, a first insulating and thermally conductive layer, an intermediate circuit layer, a second insulating and thermally conductive layer, and a substrate, wherein the second insulating and thermally conductive layer is disposed between the substrate and the intermediate circuit layer, the intermediate circuit layer is disposed between the first insulating and thermally conductive layer and the second insulating and thermally conductive layer, and the first insulating and thermally conductive layer is disposed between the top circuit layer and the intermediate circuit layer,
the switching element has a metal case to which the one electrode of the switching element is electrically connected, the metal case is configured such that an edge thereof is electrically coupled to the top circuit layer of the circuit board, the control electrode of the switching element is electrically coupled to the intermediate circuit layer of the circuit board through a via, and the another electrode of the switching element is electrically coupled to the second conductive piece through a conductive member,
wherein the substrate is attached to the second conductive piece.

23. The electrical device according to claim 15, wherein the at least one switching element comprises a plurality of switching elements, the plurality of switching elements are divided into a plurality of groups,
said one electrodes of the switching elements in each group are electrically connected together,
wherein the at least one first conductive piece comprises a plurality of first conductive pieces each of which corresponds to a group, and each switching element in the corresponding group is provided in a corresponding recess of the corresponding first conductive piece,
the electrical device further comprises a first insulating isolation structure disposed between the conductive pieces corresponding to two adjacent groups.

24. The electrical device according to claim 23, wherein the switching elements in at least one of the groups are arranged in a form of ring or a part of ring, and the switching elements of at least another group are arranged as being a central part surrounded by the ring,
wherein the at least one first conductive piece further comprises a first conductive piece corresponding to the central part, and each switching element in the central part is disposed in a corresponding recess in the first conductive piece.

25. The electrical device of claim 23, further comprising:
a second insulating isolation structure disposed between second conductive pieces corresponding to two adjacent groups.

26. An electrical device comprising:
at least one first conductive piece;
at least one switching element each comprising a control electrode and current electrodes, wherein one of the current electrodes is disposed on a first surface of the switching element and is coupled to a corresponding first conductive piece, the other electrode of the current electrodes and the control electrode are disposed on a second surface of the switching element opposite to the first surface;
at least one control electrode connecting member each comprising at least one conductive base and at least one elastic conductive structure received in the conductive base, wherein one end of each of the elastic conductive structure is coupled to a corresponding conductive base, and the other end of the elastic conductive structure is adapted to be coupled to a control electrode of a corresponding switching element to provide an electrical connection to the control electrode;
at least one second conductive piece each comprising one or more raised portions, each of the raised portion being coupled to the other electrode of the current electrodes of a corresponding switching element.

27. The electrical device according to claim 26, wherein the control electrode connecting member is placed in a recess of the second conductive piece,
the electrical device further comprises an insulating medium for electrically insulating the control electrode connecting member from the second conductive piece.

28. The electrical device according to claim 26, wherein a certain pressure is maintained between the first conductive piece and the second conductive piece.

29. The electrical device of claim 26, wherein the at least one switching element comprises a plurality of switching elements, and the plurality of switching elements are divided into a plurality of groups.

30. The electrical device of claim 29, wherein the switching elements in each group are arranged in one of the following form:
ring(s), part of ring(s), or a matrix.

31. The electrical device of claim 29, wherein the at least one control electrode connecting member is configured as one of the following:
the at least one control electrode connecting member comprises only one control electrode connecting member to use the one control electrode connecting member to electrically connect all the switching elements; or
the at least one control electrode connecting member comprises a plurality of control electrode connecting members that are independent of each other, and each control electrode connecting member is electrically connected to a switching element in a corresponding group.

32. The electrical device according to claim 26, wherein the elastic conductive structure comprises an elastic structure and a metal connecting member, and the metal connecting member is elastically supported by the elastic structure to ensure that the metal connecting member and the control electrode of the switching element are reliably connected.

33. The electrical device of claim 26, wherein the switching element is one of:
a packaged switching element; and
a switch element die.

34. The electrical device according to claim 29, wherein the one electrodes of the switching elements in each group are electrically connected together,
the at least one first conductive piece comprises a plurality of first conductive pieces, and each of the first conductive pieces corresponds to a group, and the one electrode of each switching element in the corresponding group is coupled to the first conductive piece,
the electrical device further comprises a first insulating isolation structure disposed between the conductive pieces corresponding to two adjacent groups.

35. The electrical device according to claim 34, wherein the switching elements in at least one of the groups are arranged in a form of ring or of a part of ring, the switching elements of at least another group are arranged as a central part surrounded by the ring, and the one electrode of each switching element in the central part is electrically connected together,
wherein the at least one first conductive piece further comprises a first conductive piece corresponding to the central part, and the one electrode of each switching element in the central portion is coupled to the first conductive piece.

36. The electrical device according to claim 34, wherein the at least one second conductive piece comprises a plurality of second conductive pieces, each second conductive piece corresponds to a group, and another electrode of each switching element in the corresponding group is coupled to the second conductive piece,
the electrical device further comprises a second insulating isolation structure disposed between the second conductive pieces corresponding to two adjacent groups.

37. The electrical device according to claim 35, wherein the at least one second conductive piece further comprises a second conductive piece corresponding to the central part, wherein the another electrode of each switching element in the central portion is coupled to the second conductive piece.

38. An electrical device comprising:
a power semiconductor device having a control electrode and current electrodes, the control electrodes being arranged in a ring form and disposed outside one of the current electrodes;
a driving module for driving the power semiconductor device, the driving module comprising a plurality of switching elements which are divided into a plurality of groups;
a plurality of first conductive members disposed on a side of the power semiconductor device, and used to respectively provide a connection of a corresponding switching element to the one of the current electrodes and a connection of a corresponding switching element to the control electrode, wherein at least one group of the plurality of groups of switching elements is electrically connected to the control electrode of the power semiconductor device;
one or more conductive elastic structures, one end of each elastic structure being electrically connected to a corresponding first conductive piece, and the other end being electrically connected to a corresponding switching element.

39. The electrical device according to claim 38, wherein each of the elastic structures is one of the following:
a conductive spring; or
an elastic structure comprising a conductive base, a conductive auxiliary elastic piece, and a spring, wherein the base is coupled to a current terminal of a corresponding switching element, and a recess is provided on a side of the base opposite to the corresponding switch, an end of the spring is disposed in the recess of the base and is coupled to the base, the other end of the spring is coupled to a corresponding first conductive member, the auxiliary elastic piece is provided independently of the spring, and an end of the auxiliary elastic piece is coupled to the base.

40. The electrical device according to claim 38, wherein the other end of the auxiliary elastic piece does not substantially contact the first conductive piece when an external pressure is less than or equal to a preset threshold, and when the external pressure is greater than the preset threshold, the other end of the auxiliary elastic piece is in contact with the corresponding first conductive piece, and the auxiliary elastic piece generates an elastic force in a direction opposite to a direction of the force which the other end receives.

41. The electrical device according to claim 38, wherein other groups than the at least one of the plurality of groups of switching elements are arranged in one of the following forms: a ring, a portion of a ring , or a matrix.

42. The electrical device according to claim 38, wherein the plurality of first conductive members comprise a first conductive member corresponding to the control electrode of the power semiconductor device,
the electrical structure further comprises an insulating isolation structure provided between the first conductive member corresponding to the control electrode of the power semiconductor device and other first conductive member(s).

43. The electrical device according to claim 41, wherein the other groups are arranged in a ring form or a matrix form,
the plurality of first conductive members comprise a first conductive member corresponding to the control electrode of the power semiconductor device,
the electrical structure further comprises an insulating isolation structure disposed between the first conductive members corresponding to two adjacent rings or to adjacent ring and the matrix.

44. The electrical device of claim 38, further comprising:
at least one circuit board, wherein the plurality of switching elements are disposed on a corresponding circuit board, and the one current electrode terminal and the control electrode terminal of each of the switching elements are coupled to the corresponding circuit board.

45. the electrical device of claim 38, further comprising:
at least one second conductive member coupled to the circuit board;
wherein when a pressure applied between the plurality of first conductive members and the at least one second conductive member is less than or equal to a preset pressure value, the first conductive members are not in contact with the corresponding circuit board, and the first conductive members can be connected to said one current electrode terminals of the corresponding switching elements through corresponding elastic structures;
when the pressure applied between the plurality of first conductive members and the at least one second conductive member is greater than the preset pressure value, the first conductive members are in contact with the corresponding circuit boards, and the first conductive members can be connected to the one current electrode terminals of the corresponding switching elements through the corresponding elastic structures, and also can be connected to the one current electrode terminals of the switching elements through the corresponding circuit boards, and
the one current electrode terminals are disposed on a side of the switching elements opposite to the control electrodes.

46. The electrical device according to claim 38, wherein the plurality of first conductive members comprise a conductive piece and one or more connecting members, the connecting members being disposed on a side of the conductive piece and is isolated from the conductive piece, the connecting members are connected to a part of the control electrode, and the connecting members are associated with corresponding switching elements through the elastic structures.

47. The electrical device of claim 38, further comprising:
a third conductive member coupled to a current electrode of the power semiconductor device disposed on the other surface of the semiconductor substrate; and
a package case, together with the second conductive member and the third conductive member, enclosing the power semiconductor device and the driving module.

48. An electrical apparatus comprising the electrical device according to any one of claims 1-48.
